(19) Europäisches Patentamt
European Patent Office
Office européen des brevets

(11) **EP 0 724 652 B1**

(12) **EUROPEAN PATENT SPECIFICATION**

(45) Date of publication and mention
of the grant of the patent:
**01.10.2003 Bulletin 2003/40**

(51) Int Cl.⁷: **C23C 14/34**, H01J 37/34

(21) Application number: **95910064.5**

(86) International application number:
**PCT/US94/12070**

(22) Date of filing: **21.10.1994**

(87) International publication number:
**WO 95/012003 (04.05.1995 Gazette 1995/19)**

(54) **METHOD AND APPARATUS FOR SPUTTERING MAGNETIC TARGET MATERIALS**

VERFAHREN UND VORRICHTUNG ZUM SPUTTERN VON MAGNETISCHEM TARGETMATERIAL

PROCEDE ET APPAREIL DE PULVERISATION DE MATERIAUX CIBLES MAGNETIQUES

(84) Designated Contracting States:
**AT BE CH DE DK ES FR GB GR IE IT LI LU MC NL PT SE**

(30) Priority: **22.10.1993 US 142162**
**01.04.1994 US 221941**

(43) Date of publication of application:
**07.08.1996 Bulletin 1996/32**

(73) Proprietor: **Manley, Kelly**
**Boulder, Colorado 80301 (US)**

(72) Inventor: **MANLEY,Barry**
**Boulder, CO 80301 (US)**

(74) Representative: **Goddar, Heinz J., Dr. et al**
**FORRESTER & BOEHMERT**
**Pettenkoferstrasse 20-22**
**80336 München (DE)**

(56) References cited:
**EP-A- 0 381 437**      **US-A- 4 865 708**
**US-A- 4 892 633**      **US-A- 4 964 968**

**Description**

1. Technical Field

This invention relates generally to the field of magnetron sputtering and more specifically to planar magnetron sputtering apparatus for sputtering magnetic target materials.

2. Background Art

Glow discharge sputtering is a well-known process that is widely used to deposit thin films of various kinds of ceramic and metallic materials onto the surfaces of objects. For example, glow discharge sputtering is commonly used in the electronics industry to produce integrated circuit semiconductors and photovoltaic cells, as well as the magnetic tapes and disks used in audio, video, and computer applications. Sputtering is also used to deposit coatings on architectural glass, computer screens, sheet metal, sunglasses, automobile parts, automobile glazing, surgical implants, jewelry, tool bits, sheet plastic, fabrics, and fiber optics, just to name a few.

One type of glow discharge sputtering is diode sputtering. Diode sputtering is usually conducted in a vacuum chamber and in the presence of an inert sputtering gas, such as argon, that is maintained under very low pressure. The material to be sputtered (usually referred to as the target) is connected to the negative terminal of a DC power supply and serves as a cathode. The positive terminal of the power supply may be connected to a separate anode structure or to the vacuum chamber itself, depending on the application. The strong electric field between the target/cathode and the anode ionizes the sputtering gas, producing a glow discharge. Since the target/cathode is held at a strong negative potential, the positive ions from the glow discharge bombard the target material and eject target atoms, which then deposit on a work-piece or a substrate placed generally in line of sight of the target. Unfortunately, however, the diode sputtering process is slow and relatively inefficient compared to other film deposition techniques.

The efficiency of the diode sputtering process has been significantly increased by using a magnetic field to confine the glow discharge to the immediate vicinity of the target surface. Basically, while the sputtering yield (i.e., the number of target atoms dislodged or sputtered per incident ion) depends on the energies of the incident ions, the overall sputtering rate depends on both the energies of the incident ions as well as the total number of ions that bombard the target surface during a given time. Therefore, the sputtering rate can be increased by using a magnetic field to confine the ions and electrons produced in the glow discharge to the region immediately adjacent the surface of the target. The presence of such a plasma-confining magnetic field also has other benefits, such as allowing the sputtering operation to be conducted at lower gas pressures, confining the glow discharge to the neighborhood of the electrodes, and reducing electron bombardment of the substrates.

A common type of magnetic sputtering device is the planar magnetron, so named because the target is in the form of a flat circular or rectangular plate. Powerful magnets placed behind the target plate produce a strong plasma-confining magnetic field adjacent the front surface of the target, thus greatly increasing sputtering efficiency. While numerous shapes and configurations of plasma-confining magnetic fields exist, it is common to shape the plasma-confining magnetic field so that it forms a closed loop ring or "racetrack" over the surface of the target material. When viewed in cross-section, the flux lines of the magnetic field loop or arch over the surface of the target, forming a magnetic "tunnel," which confines the glow discharge to a ring or racetrack shaped sputtering region next to the front surface of the target. As is well-known, the electric field created by the high voltage between an anode and the target/cathode acting in combination with the closed loop magnetic field causes electrons within the glow discharge to gain a net velocity along the racetrack, with the magnitude and direction of the electron velocity vector being given by the vector cross product of the electric field vector **E** and the magnetic field vector **B** (known as the **E** x **B** velocity). The shape of the predominate electron path defines the portion of the target material that will be sputtered.

While planar magnetrons are widely used to sputter non-magnetic target materials, such as aluminum and its alloys, they have not proven particularly efficient for sputtering magnetic materials having magnetic permeabilities significantly greater than 1, such as, for example, iron, nickel, iron-nickel alloys, and cobalt-chromium alloys. Simply replacing a non-magnetic target in a planar magnetron with a ferromagnetic target of the same general configuration usually causes most, if not all, of the magnetic field to be shunted through the magnetic target. This reduces the intensity of the plasma-confining magnetic tunnel above the target to the point where it can no longer effectively confine the plasma over the surface of the target, thus reducing planar magnetron sputtering to that of ordinary diode sputtering with its attendant relatively slow sputter rate and inefficiency,

One solution to the problem of sputtering magnetic target materials (i.e., materials having magnetic permeabilities significantly greater than 1) has been to use very thin targets, so that the target does not short out the entire magnetic field. If the target is thin enough (approximately 2-3 mm for a highly ferrous material), sufficient excess magnetic flux will remain over the front surface of the target to produce a plasma-confining magnetic tunnel. Unfortunately, however, such thin targets are rapidly depleted, thus requiring frequent replacement and substantial downtime of the sputtering apparatus.

Another solution to the problem has been to strengthen the magnetic field so that thicker targets can be sputtered. Of course, since a thicker target tends to shunt more of the magnetic flux, the magnetic field must be sufficiently strong to produce a plasma-confining magnetic tunnel over the front surface of the target. Usually a field strength in the range of about 80-100 gauss in a direction parallel to the target surface is required to achieve the magnetron effect. While stronger magnets are more expensive, they can, at least theoretically, result in a magnetron suitable for sputtering magnetic targets of sufficient thicknesses to offset the additional cost of the stronger magnets. Unfortunately, however, sputtering magnetrons designed for use with magnetic target materials suffer from another problem that has proven much more difficult to overcome: Namely, severe magnetic pinching of the plasma.

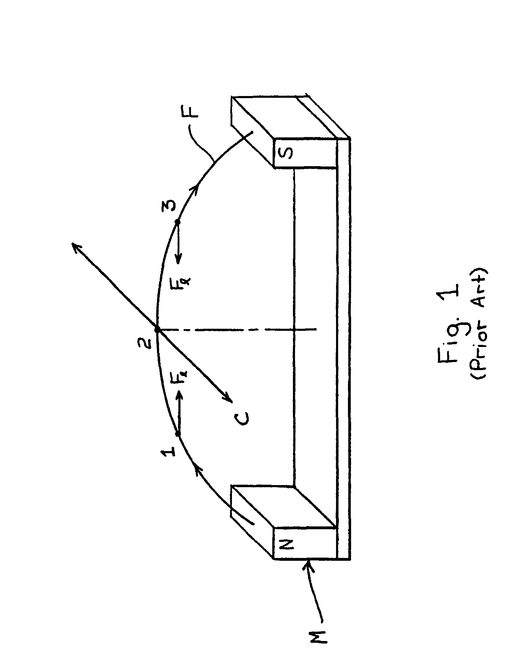

The magnetic pinching phenomenon is best understood by referring to Figure 1 which illustrates, in schematic form, the forces acting on electrons in the region of the magnetic tunnel. In a prior art magnetron, a magnet assembly M produces a magnetic field that can be characterized by a plurality of magnetic flux lines F, one of which is shown in Figure 1. The flux line F shown in Figure 1 is representative of the field shape immediately adjacent the front surface of the target. Points I and 3 are points in the central region of the tunnel, to the left and right of the central axis C respectively. Point 2 is a point on the central axis C of the tunnel, coincident with the flux line F. The target locations within the tunnel fields are such that each of the points 1, 2, arid 3 will be coincident with the front surface of the target at some time during the sputtering process. As is well-known, the curvature of the magnetic field F subjects electrons positioned at points 1 and 3 to lateral forces $F_1$ that tend to push them toward the central axis C of the tunnel. Since the magnetic field has no vertical component (i.e., a component orthogonal to the plane of the pole piece) at point 2, no lateral forces are exerted on electrons at point 2. The action of the lateral forces $F_1$ on the electrons in the plasma tends to force or pinch them toward the central axis C of the magnetic tunnel. Since the erosion caused by sputtering is related to the density of the electrons in the glow discharge plasma, the effect of the pinching phenomenon increases the erosion rate along the central axis C of the magnetic tunnel.

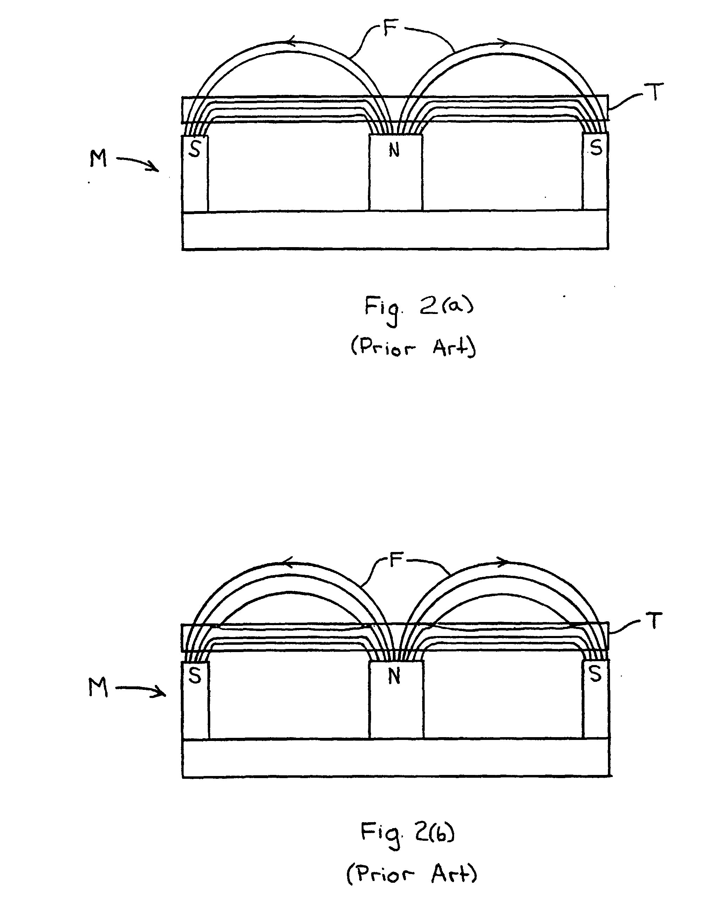

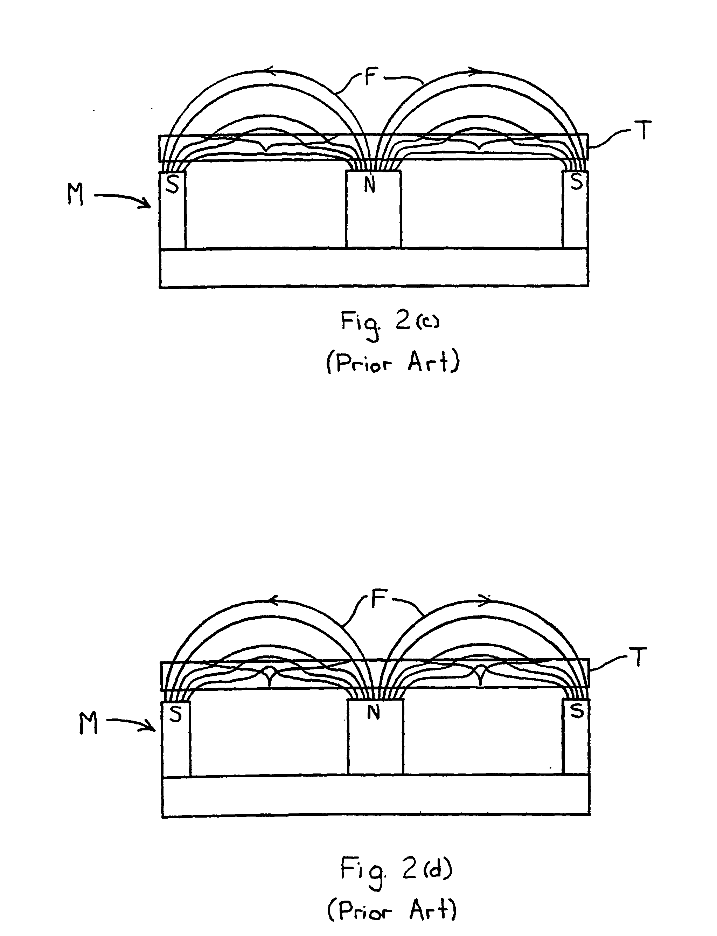

While this pinching phenomenon occurs in all types of planar magnetrons with arched magnetic tunnels, the problem becomes much worse when sputtering magnetic target materials, as best seen in Figures 2(a)-(d). When sputtering a magnetic target T, a large portion of the magnetic flux F (shown qualitatively in Figures 2(a)-(d)) produced by the magnet assembly M will be shunted through the magnetic target. However, if the magnetic field is strong enough, sufficient magnetic flux will remain over the front surface of the target to produce an arched, plasma-confining magnetic tunnel. As was explained above, the pinching forces resulting from the arched magnetic tunnel will initially pinch the electrons toward the center of the tunnel, resulting in the greatest erosion rate at that point. However, as the target erodes, its cross-sectional area decreases, thus forcing additional magnetic flux from the target. Since the excess magnetic flux always takes the lowest energy path (i.e., the path of least resistance), it usually exits the target surface in the erosion area and re-enters the target just as soon as the cross-sectional area has increased to the point where the target material can again accommodate the excess flux. The liberated magnetic flux arching over the front surface of the target subjects electrons within the glow discharge plasma to even greater pinching forces, which substantially increases the electron density, thus erosion rate, along the center of the tunnel, as best seen in Figure 2(c). As the target erodes further, more and more magnetic flux is liberated, resulting in stronger pinching forces, higher electron densities, and greater erosion rates. The result is a deep, spike-like erosion groove in the target, as best seen in Figure 2(d).

The fraction of the target material that has been sputtered away by the time the bottom of the erosion groove reaches the back surface of the target is referred to as the target utilization, and is extremely low for most magnetic targets, in the range of 5 %-15 % at best. Since most target materials tend to be relatively expensive, such low target utilization is wasteful and increases the costs associated with the sputtering process. For example, although spent targets may be recycled and reworked into new targets, the time spent changing and reworking targets can be significant and in any event, increases the overall cost of the sputtering operation.

Another solution to the problem has been to place external magnets above and around the target to generate the plasma-confining magnetic tunnel.' However, such systems are prone to the pinching effect described above, and also add considerable complexity, thus cost, to the magnetron assembly. Moreover, unless properly shielded, the additional magnets themselves may sputter and contaminate the coating.

Yet another approach has been to reduce the strength of the magnetic field required to saturate the target material. Since a magnetic material heated above its Curie temperature loses its ferromagnetism. magnetron sputtering of a ferromagnetic target can be more easily accomplished by heating the target material above its Curie temperature. A disadvantage of this approach is that it requires a device for monitoring the temperature of the target as well as a system for achieving and maintaining the required Curie temperature. Also, since the Curie temperature of most ferromagnetic materials is quite high, in the range of 400° C to 1100° C, heating the target material to such temperatures can damage the substrate being coated or other parts of the vacuum system. Another disadvantage is that most high performance permanent magnets loose their magnetic properties at temperatures above about 150° C to 200° C, so a cooling system must be provided to maintain the permanent magnets below the critical temperature.

While still other modifications have been developed, each is not without its problems. For example, US-A-4,652,358 attempts to solve the target thickness problem by placing the ferromagnetic target on a specially configured floor located between the target and the magnet assembly. While most of the floor is made from a non-magnetic material, it includes special ferromagnetic inserts in the regions of the poles of the magnet system to improve the magnetic coupling efficiency, thereby lowering the magnetic field density required to saturate the target. Unfortunately, the floor is difficult and expensive to manufacture and, in the preferred embodiment, requires that the ferromagnetic plugs be joined to the non-magnetic floor by electron beam welding to minimize mechanical stress and to produce gas-tight and liquid-tight joints. Moreover, the pinching problem is not addressed, leaving this device with poor target utilization.

US-A-4,401,539 discloses a method and apparatus for sputtering magnetic target materials that uses a combination of permanent magnets and electromagnets to generate the strong leakage flux density over the target surface required to create the plasma-confining magnetic tunnel. It is attemped to minimize the pinching problem by using the electromagnets to vary the strength and configuration of the magnetic field during the sputtering process. Unfortunately, however, the computer controlled electromagnet assembly is complex and expensive to fabricate.

US-A- 4,500,409 discloses a planar magnetron for sputtering highly ferromagnetic targets that uses only electromagnets to produce the plasma-confining magnetic field over the target surface. The pinching problem is addressed by varying the strength of the magnetic field produced by the electromagnets. However, like the magnetron disclosed in US-A-4,401,539 the magnetron of US-A-4,500,409 is relatively complex and expensive to manufacture. Moreover, the design constraints associated with most magnetron cathode assemblies tends to limit the size of the electromagnets and the resulting magnetic field, thus requiring the use of relatively thin targets.

US-A-4,391,697 and US-A-4,431,505 disclose yet another type of magnetron sputtering apparatus for sputtering ferromagnetic targets. The device utilizes a two piece target with a gap between the pieces. While most of the applied magnetic field concentrates in the gap between the target pieces, there remains sufficient excess flux to form a weak plasma trapping field over the surface of the target. The gap serves as a plasma source, which plasma then migrates to the trapping field to sputter the target. Disadvantageously, the two piece target required by the device is relatively complex. Also even though it is recognized that the gap floor can sputter, thus possibly contaminating the coating or, worse yet, erode through to the magnet assembly, those disavantages seem to be accepted as the price to be paid for sputtering ferromagnetic materials.

Finally, US-A-4,572,776 attempts to achieve magnetron sputtering of a magnetic target by using a ferromagnetic pole shoe assembly to assist in producing a plasma-confining tunnel over the surface of the target. Unfortunately, portions of the ferromagnetic pole shoe assembly do sputter, thus requiring that it be made of the same material as the target, or else risk contaminating the coating. However, if the pole shoe is made of the same material as the target, then any cost advantages are lost, and the device simply becomes another magnetron having a two-piece target. Also, the pole shoe and target assemblies must be positioned with respect to each other at certain specifically defined spacings and tolerances that may be difficult to maintain during the sputtering operation.

In sum, while the foregoing devices represent some improvements, they have usually come at the expense of decreased power efficiency, decreased target replacement intervals, or have required two-piece target configurations or the addition of separate or additional electromagnetic coils, along with apparatus to control the electromagnets. Besides increasing the overall cost of the sputtering device, the addition of large numbers of components into the sputtering chamber may poison the sputtered film with unwanted impurities if suitable precautions are not taken to insure that the additional components themselves do not sputter. Also, few of the prior art references provide an effective solution to the magnetic pinching problem

The documents US-A-4, 964, 968 and EP-A-0 381 437 are directed to a magnetron sputtering device having a gradient adjusting means, i.e. a shunt, to reduce the vertical component of the leakage magnetic field over the target.

There remains a need for a planar magnetron that can sputter ferromagnetic targets without the severe disadvantages that result from the magnetic pinching problem. Such a magnetron should also be capable of achieving high target utilization rates, but without the need to resort to complex target configurations. electromagnet assemblies or, worse yet, magnet assemblies containing both electromagnets and permanent magnets. Such a permanent magnet magnetron should also be capable of sputtering a relatively thick ferromagnetic target without having to heat it to its Curie temperature.

## DISCLOSURE OF INVENTION

Accordingly, it is a general object of the invention to provide a magnetron sputter coating source for sputtering magnetic targets.

It is another object of this invention to provide a magnetron sputter coating source having increased target utilization.

A further object is to sputter magnetic target materials at temperatures below the Curie temperatures of the materials.

It is yet another object of this invention to reduce magnetic pinching of the glow discharge associated with magnetic target materials.

It is yet a further object to provide a magnetron sputtering source that does not require electromagnets to reduce magnetic pinching of the glow discharge plasma.

Still another object of this invention is to provide a magnetron sputter coating source for sputtering a single piece planar magnetic target.

Additional objects, advantages, and novel features of this invention shall be set forth in part in the description that follows, and in part will become apparent to those skilled in the art upon examination of the following or may be learned by the practice of the invention. The objects and the advantages of the invention may be realized and attained by means of the instrumentalities and in combinations particularly pointed out in the appended claims.

To achieve the foregoing and other objects and in accordance with the purposes of the present invention, as embodied and broadly described herein, a sputtering magnet assembly according to claim 1 and an assembly of a magnetron sputtering cathode and a target of claim 7 are provided.

## BRIEF DESCRIPTION OF THE DRAWINGS

The accompanying drawings, which are incorporated herein and form a part of the specification illustrate the preferred embodiments of the present invention, and together with the description, serve to explain the principles of the invention. In the drawings:

Figure 1 is a schematic perspective view of a prior art sputtering magnetron qualitatively showing an arched magnetic flux line of the magnetic tunnel and the forces acting on electrons at various points;

Figures 2(a)-(d) are schematic cross section views in elevation of a prior art sputtering magnetron for sputtering a magnetic target qualitatively showing the configuration of the magnetic tunnel and the erosion pattern resulting from the magnetic pinch phenomenon;

Figure 3 is a qualitative graphical representation of the initial branches of the magnetic hysteresis curves for a hard magnetic material and for a soft magnetic material;

Figure 4 is a plan view of a first embodiment of the sputtering magnet assembly according to the present invention for sputtering a rectangular target with a portion of the target broken away to show the positions and orientations of the magnets and the magnetic shunt;

Figure 5 is a schematic cross section view in elevation of the sputtering magnet assembly according to the present invention taken along the lines 5-5 of Figure 4 and showing the position of the target with respect to the magnet assembly and the magnetic shunt;

Figure 6 is a cross section view in elevation of the first embodiment of the sputtering magnet assembly shown in Figures 4 and 5, including a computer generated plot of the magnetic field;

Figure 7 is a cross section view in elevation of a magnet and target assembly, including a computer generated plot of the magnetic field;

Figure 8 is a cross section view in elevation of the magnet and target assembly shown in Figure 7, but with the addition of a magnetic shunt;

Figure 9 is a cross section view in elevation of the magnetron assembly shown in Figure 8, but with the shunt slightly relocated to optimize the configuration of the magnetic field;

Figure 10 is a plan view of a second embodiment of the sputtering magnet assembly for sputtering a circular target, but with the target removed to show the positions and orientations of the magnets and magnetic shunt;

Figure 11 is a schematic cross section view in elevation of the sputtering magnet assembly taken along the lines 11-11 of Figure 10 showing the position of the target with respect to the magnet assembly and magnetic shunt;

Figure 12 is a cross section view in elevation of a circular magnet and target assembly of the types shown in Figures 10 and 11 showing a computer generated plot of the magnetic field;

Figure 13 is a cross section view in elevation of the magnet assembly shown in Figure 12, but with the addition of a magnetic shunt;

Figure 14 is a cross section view in elevation of the magnet assembly shown in Figure 13, but with the width and position of the shunt slightly changed to optimize the configuration of the magnetic field;

Figure 15 is a cross section view in elevation of a third embodiment of the sputtering magnet assembly for sputtering wide rectangular targets or large diameter circular targets;

Figure 16 is a plan view of a fourth embodiment of a sputtering magnet assembly having a two piece shunt for sputtering magnetically soft rectangular targets;

Figure 17 is a schematic cross section view in elevation of the sputtering magnet assembly taken along the lines 17-17 of Figure 16 and showing the position of the target with respect to the magnet assembly and the two piece magnetic shunt;

Figure 18 is a cross section view in elevation showing a computer generated plot of the magnetic field configuration produced by a magnet assembly shown in Figures 16 and 17;

Figure 19 is a cross section view in elevation of the magnet assembly shown in Figure 18, but with the two piece shunt slightly reconfigured and relocated to optimize the configuration of the magnetic field; and

Figure 20 is a cross section view in elevation of another embodiment of the sputtering magnet assembly having a two piece shunt for sputtering wide rectangular targets or large diameter circular targets.

## BEST MODE FOR CARRYING OUT THE INVENTION

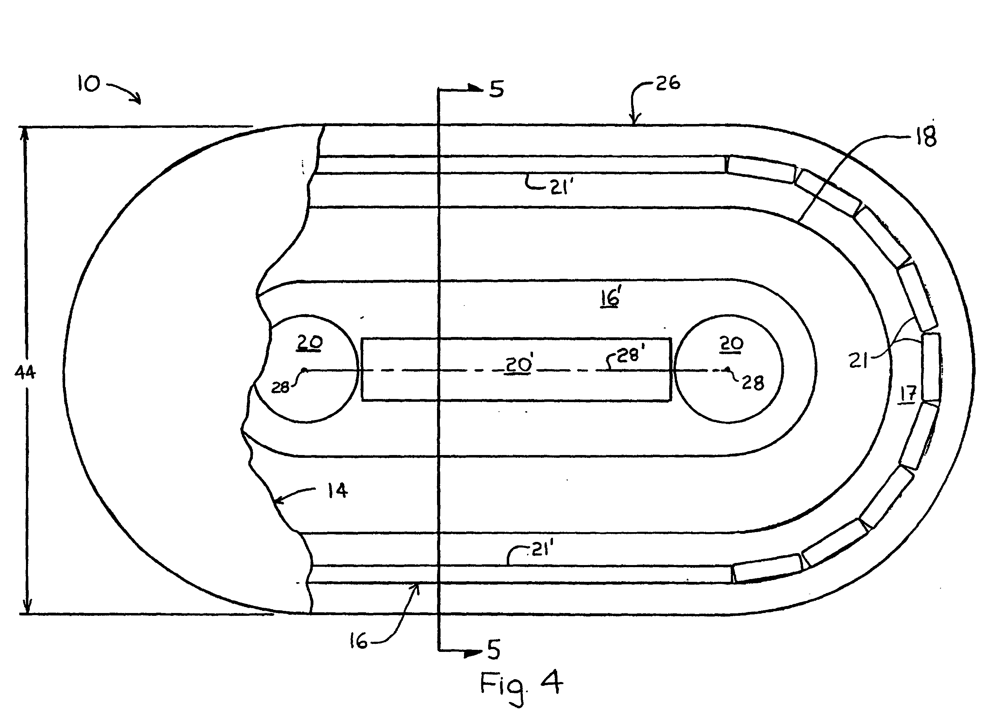

The sputtering magnet assembly 10 according to the present invention is best seen in Figures 4, 5, and 6 as it is configured to generate a closed loop magnetic tunnel 24 over the front surface 12 of a flat rectangular ferromagnetic target 14. The magnetic tunnel 24 includes two linear sections in parallel-spaced-apart relation extending along most of the length of the rectangular target 14 that are joined at each end by a semi-circular end section, thus forming a continuous magnetic tunnel in the shape of a flattened oval or racetrack. The magnet assembly 10 is similarly shaped and comprises a flattened oval shaped base pole piece 16 mounted within a cathode assembly 26. Each semi-circular end section 17 of the base pole piece 16 includes a central magnet 20 positioned at the radius center or axis of symmetry 28 of the semi-circular end section 17 and is oriented so that its north pole N is adjacent the back surface 22 of target 14. A plurality of outer magnets 21 surround the central magnet 20 and have opposite magnetic orientations, i.e., their south poles S are adjacent the back surface 22 of target 14. The configuration of the elongated rectangular center section 16' of base pole piece 16 is similar to the configuration of each semi-circular end section, with the only difference being that the magnets are arranged in a linear configuration, as opposed to a circular configuration. Specifically, the center section 16' includes an elongated central magnet 20' that extends between each cylindrical central magnet 20. Likewise, a pair of elongated outer magnets 21' extend between the outer magnets 21 in each semi-circular end section, as best seen in Figure 4. A magnetic shunt 18 in the shape of a flattened oval is positioned between the central magnets 20 and 20' and the outer magnets 21 and 21' and is close to the back surface 22 of ferromagnetic target 14.

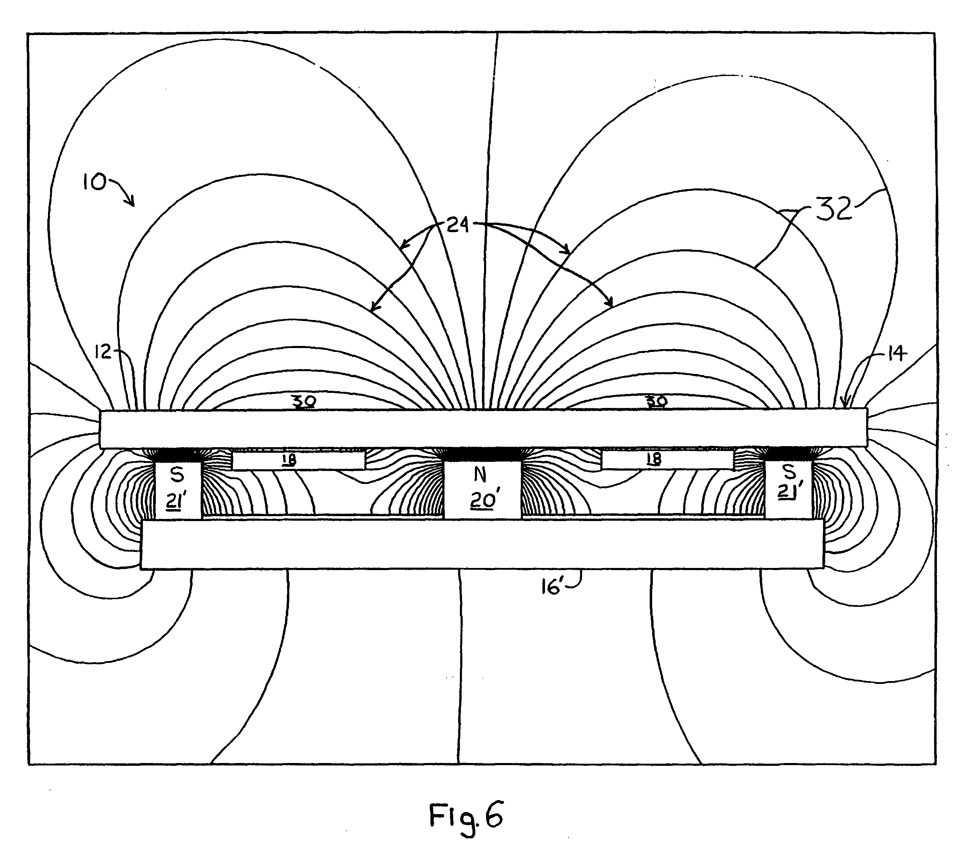

The combination of central magnets 20 and 20', outer magnets 21 and 21', base pole piece 16, and shunt 18, all of which form the magnet assembly 10, produce a racetrack shaped magnetic field that can be represented by a plurality of magnetic flux lines 32, shown in Figure 6, which is drawn to scale. Actually, Figures 6-9, 12-14, and 18-20 herein are all drawn to scale and the magnetic flux lines shown therein were generated by a finite element computer modeling program of the kind that are readily commercially available and well-known to persons having ordinary skill in the art. In those drawings, the spacing between the flux lines is proportional to the magnetic flux density, i.e., field strength. The closer the line spacing, the stronger the magnetic field. In the interest of clarity, the flux lines inside the magnets and pole pieces are not shown.

While most of the magnetic flux is shunted through the target 14, sufficient magnetic flux remains over the front surface 12 of target 14 to produce a plasma-confining magnetic tunnel 24, as best seen in Figure 6. The plasma-confining magnetic tunnel 24 defines a sputtering region 30 that is adjacent the front surface 12 of target 14. A portion of the magnetic flux also passes through the shunt 18, but does not magnetically saturate shunt 18.

When sputtering a new target 14, the plasma-confining magnetic tunnel 24 confines the glow discharge (not shown) substantially to the area of the sputtering region 30, thus achieving the magnetron effect and maximizing sputtering efficiency. As the front surface 12 of the ferromagnetic target 14 erodes, its cross-sectional area is gradually reduced, thus forcing some of the magnetic flux that had been shunted through the target to find an alternate path. In the prior art apparatus, that excess flux tended to emerge from the front surface of the target, loop into the sputtering region, and re-enter the target plate when the cross-sectional area again became great enough to accommodate the excess flux. As was described above, the escape of the excess magnetic flux into the sputtering region resulted in severe magnetic pinching forces that ultimately produced a very narrow, spike-like erosion groove that would quickly reach the back surface of the target before barely 10% of the target material had been sputtered.

In contrast to the prior art, the magnetic shunt 18 of the present invention provides a lower energy pathway for most of the excess magnetic flux liberated by target erosion. In the present invention, then, the excess magnetic flux liberated from the gradually eroding target emerges from the back surface of the target, passes through the shunt 18, and re-enters the target material when the cross-sectional area of the target 14 is again sufficient to accommodate the excess flux. By preventing the excess magnetic flux from emerging into the sputtering region 30, the present invention substantially reduces the magnetic pinching forces in the sputtering region, thus significantly increasing target utilization.

Another significant advantage of the magnet assembly 10 according to the present invention is that it can be used to sputter relatively thick targets without the need to raise the temperature of the target material above its Curie temperature. The ability to sputter thicker targets increases the production run for a given target and reduces the downtime associated with target recycling and target replacement. Furthermore, since the present invention uses simple static magnetic fields to produce the increased target utilization, it does not require complex mechanical or electromagnetic apparatus to move the magnetic field with respect to the target, with all their associated disadvantages. Consequently, the entire sputtering magnet assembly according to the present invention may be coated with an inert insulating material to prevent the magnet assembly from corroding if it is immersed in water or some other coolant.

While magnetic shunts have been used in some types of planar magnetrons to sputter non-magnetic targets, they have never been successfully used with magnetic target materials, doubtless because the teachings associated with those devices are not applicable to the special problems associated with sputtering magnetic target materials.

For example, Welty, in U.S. Patent No. 4,892,633, teaches the use of a magnetic shunt positioned adjacent the back surface of the target to reduce the effect of magnetic pinching on non-magnetic target materials. Welty uses his shunt to produce an inflection point or "dip" in the magnetic field near the center of the plasma-confining tunnel. The purpose of the dip is to force electrons in the plasma away from the tunnel center, thus increasing the uniformity of the electron density within the plasma, and producing a more uniform erosion rate. However, if Welty's field is used in conjunction with a magnetic target, it achieves the opposite result. That is, Welty's dipped magnetic field will result in two deep, spike-like erosion grooves on either side of the dip, with little or no sputtering occurring elsewhere. Welty's device does not work with magnetic target materials because the excess magnetic flux liberated by the erosion of a magnetic target tends to concentrate in the convex field regions adjacent either side of the dip, which of course, magnifies the pinching forces, as described earlier. However, since no excess magnetic flux is liberated by the erosion of a non-magnetic target, there was no need for Welty to consider the effect of the liberated magnetic flux on the performance of his invention.

Before proceeding with detailed descriptions of the various preferred embodiments of the invention, it should be noted that while the present invention can be used to sputter all types of ferromagnetic target materials, not all ferromagnetic materials have the same magnetic properties, and the various embodiments shown and described herein may include minor configuration changes depending on the type of ferromagnetic material for which they are to be used. For example, one preferred embodiment used to sputter cobalt alloy, a relatively "hard" ferromagnetic material, includes the use of a one piece magnetic shunt. However, other embodiments, intended to be used with softer ferromagnetic target materials, such as iron or nickel, or their alloys, utilize a two piece, split shunt.

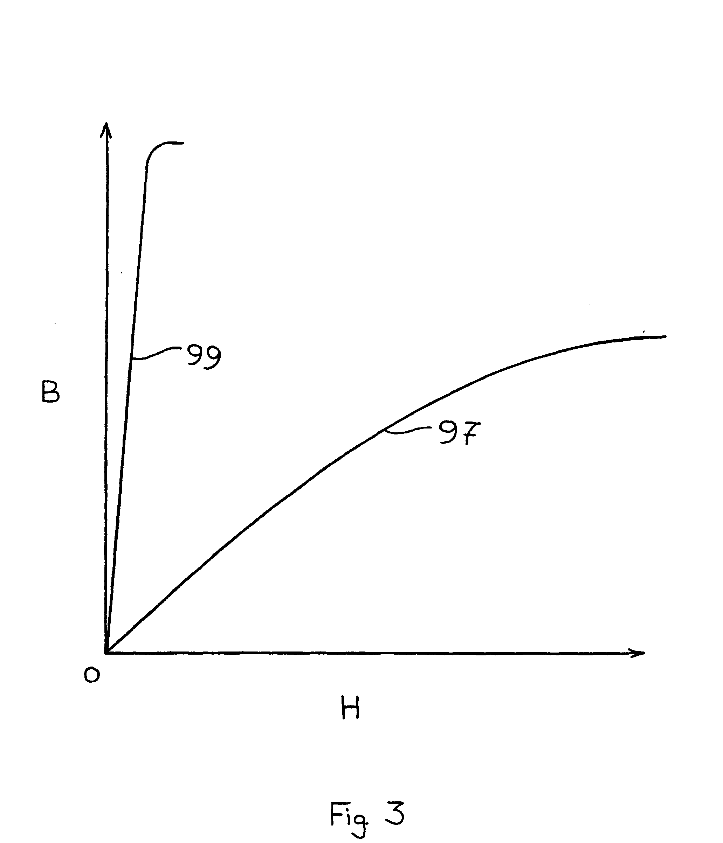

The relative hardness or softness of a ferromagnetic material is an indication of the ease with which it can be magnetized. Soft magnetic materials, such as iron, are easily magnetized (i.e., saturated), while harder materials, such as cobalt, are more difficult to magnetize. Put in other words, if a relatively large applied magnetic field is required to magnetically saturate the material, then the material is considered to be magnetically hard. Conversely, if the material becomes magnetically saturated under the influence of a small applied field, then the material is magnetically soft. The relative hardness or softness of a ferromagnetic material can also be determined by the slope of the initial branch of its magnetic hysteresis curve. See Figure 3. The initial branch 97 of the hysteresis curve for a hard magnetic material, such as cobalt, generally has a relatively flat slope in the range of about 0.06 gauss-m/A, whereas the slope of the hysteresis curve 99 for a soft magnetic material, such as iron, is in the range of about 7 gauss-m/A. While the slope of the initial hysteresis curve for a particular material can vary by a factor of ten (10) or more depending on the particular composition of the material, the slopes of the initial hysteresis curves for the two types of magnetic materials generally differ by about two orders of magnitude (i.e., about 100 times). These differences between hard and soft ferromagnetic materials can have a significant effect on the configuration of the magnet structure and shunt assembly necessary to achieve the objects of the present invention, as will be described in much greater detail below.

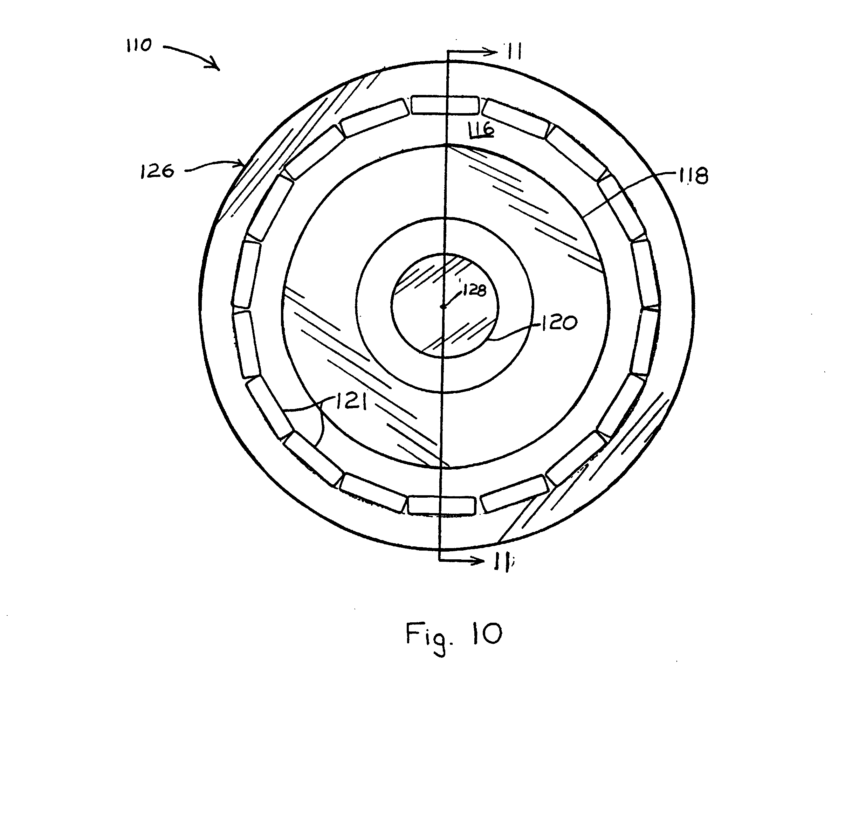

It should also be noted that the magnet and shunt assembly may take on different configurations depending on the particular target shape and the desired erosion pattern. For example, the embodiments shown in Figures 4-9 and 16-20 are specifically configured to sputter rectangular targets, so the magnet and shunt assemblies are configured to produce plasma-confining tunnels having two linear sections in parallel, spaced-apart relation that extend along most of the length of the rectangular targets. The linear sections are joined at each end by semi-circular sections, thus forming continuous magnetic tunnels in the shapes of flattened ovals or racetracks. On the other hand, if the magnetron is to be used to sputter circular targets, such as the embodiments shown in Figures 10-14 and 15, then the magnet and shunt assemblies are configured to produce plasma-confining magnetic tunnels in the shapes of circular rings.

Finally, since the details of the other components required to construct and operate a planar magnetron sputtering apparatus, such as the vacuum chamber, apparatus for mounting and cooling the cathode/target, and apparatus for electrically connecting the cathode/target to the voltage source, etc., are well known to persons having ordinary skill in the art, such other components are not shown and described herein. Persons skilled in the art would also recognize the need to surround the magnet assembly with a suitable ground shield to prevent unwanted sputtering of the magnet assembly and to prevent arcing.

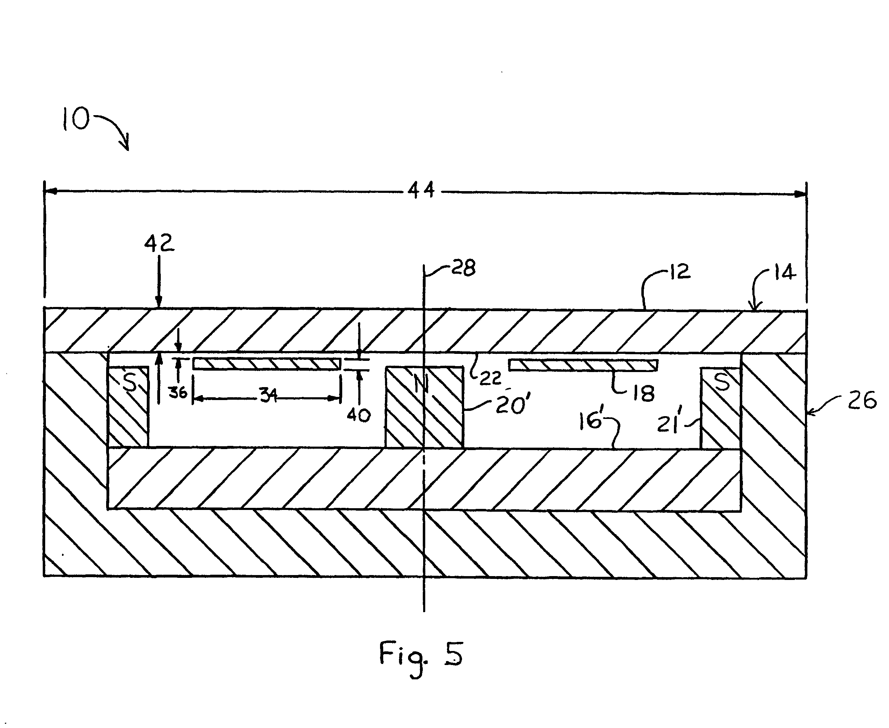

Referring now to Figures 4-6, the sputtering magnet assembly 10 is specifically configured to generate a racetrack-shaped magnetic tunnel 24 for sputtering a plate-like rectangular target of cobalt alloy (a relatively hard magnetic material) having a mean width 44 of about 12.7 cm (5 in) and a mean thickness 42 of about 0.80 cm (0.31 in). Note that the length of the rectangular target has little, if any, effect in achieving the objects of the present invention, and the length of the rectangular target can be selected depending on the particular requirements of the application. Since the magnet assembly 10 is specifically configured to sputter a rectangular target, base pole piece 16 is in the shape of a flattened oval and is constructed from a magnetically permeable material, such as Permalloy, iron, or nickel, to minimize magnetic losses. The individual magnets 20, 20', 21, and 21' are likewise arranged in the shape of a flattened oval directly on the base pole piece 16, as best seen in Figure 4. Specifically, each cylindrical central magnet 20 is mounted to base pole piece 16, concentric with the radius center or axis of symmetry 28 of each semi-circular end section 17. Each cylindrical central magnet 20 is oriented so that its north pole N is immediately adjacent the back surface 22 of target 14. The elongated central magnet 20' extends between each cylindrical central magnet 20 and is aligned with a longitudinal axis 28' connecting each axis of symmetry 28. A plurality of outer magnets 21 and 21' are mounted to the outer periphery of base pole piece 16 and have magnetic orientations opposite the central magnets 20 and 20', i.e., the south poles S of the outer magnets 21 and 21' are immediately adjacent the back surface 22 of target 14, as best seen in Figures 4 and 5. In the preferred embodiment, each cylindrical central magnet 20 is 9.5 mm high and has a diameter of 25 mm, while the elongated central magnet 20 is 9.5 mm high, 13 mm wide, and sufficiently long to extend between the two cylindrical magnets 20. The outer magnets 21 are each 9.5 mm high and 8 mm wide, while the two elongated outer magnets 21' are each 9.5 mm high, 8 mm wide, and sufficiently long to extend between the outer magnets 21 at each semi-circular end section 17. Alternatively, and as would be obvious to persons having ordinary skill in the art, a plurality of smaller magnets, arranged end-to-end, could be substituted for the single elongated central magnet 20' or for each of the single elongated outer magnets 21'. All magnets are rare earth Neodymium Iron Boron (NdFeB) and have magnetic field energy products of at least 35 megagauss-oersted (MGOe). However, other types of rare earth magnets, such as Samarium Cobalt (SmCo) magnets, may be substituted with equal effectiveness. Also, the relative north-south orientations of the magnets are arbitrary, and persons having ordinary skill in the art would recognize that the invention would work equally as well if the respective north-south orientations of the magnets were reversed.

A magnetic shunt 18 in the form of a flattened oval or racetrack has a width 34 and a thickness 40 and is disposed between the central magnets 20 and 20' and the outer magnets 21 and 21', as best seen in Figures 4 and 5. Shunt 18 is positioned adjacent the back surface 22 of target 14 so that a gap 36 exists between the shunt 18 and the back surface 22 of target 14. Since the purpose of the magnetic shunt 18 is to provide a lower energy pathway for excess magnetic flux, thus prevent the flux from emerging into the sputtering region, the dimensions of the gap 36 as well as the width 34 and thickness 40 of the shunt are important in achieving the objects of the invention. The following discussion is directed to a method of determining those parameters.

In the preferred embodiment, magnetic coupling of the magnetic flux produced by the magnets 20, 20', 21, and 21' is achieved by placing the magnets directly on the base pole piece 16. The magnetic flux is carried in closed magnetic circuits which consist of the magnets 20, 20', 21, and 21' the base pole piece 16, the target 14, and the shunt 18. As is well-known in the art, the following condition must be satisfied to magnetically saturate the target and produce the plasma-confining magnetic tunnel 24 over the front surface 12 of target 14:

$$\Phi_L > M_s t \qquad (1)$$

Where:

$\Phi_L$ = magnetic flux per unit length produced by the magnet assembly;
$M_s$ = saturation magnetization of the target material; and
$t$ = target thickness.

Thus, for a given magnetic field strength and a given target material, the thickness 42 of target 14 is the critical parameter to ensure that the target material is magnetically saturated.

As was described above, a magnetic field strength of at least 80-100 gauss in a direction parallel to the target surface is required to achieve the magnetron effect. Therefore, it is necessary to provide a magnet assembly of sufficient capacity to ensure that the strength of the magnetic field produced over the front surface of the target will be sufficient to confine the glow discharge plasma over the front surface of the target. For a relatively hard magnetic material, such as cobalt or cobalt alloy, a magnet assembly substantially as described above will be sufficient to so confine the plasma. However, since softer magnetic materials, such as iron and nickel, or their alloys, tend to shunt a much larger portion of the magnetic field produced by the magnet structure, and may even become magnetically saturated under certain conditions, it will usually be necessary to resort to stronger magnets or thinner targets to ensure that the magnetic field over the front surface of the target will have sufficient strength to confine the plasma, as will be described in greater detail below.

Regardless of whether the magnetic material is hard or soft, the magnetic circuit should be arranged to minimize losses and coupling inefficiencies, thus maximize the allowable target thickness. For example, such magnetic losses can be minimized by using highly permeable materials for the base pole piece 16 such as, for example, Permalloy, soft iron, or nickel, and by providing the base pole piece 16 with adequate cross-sectional area. If at the same time a magnet structure of sufficient capacity is provided (i.e., Equation 1 is satisified), the excess magnetic flux in front of the target will form a plasma-confining magnetic tunnel of sufficient strength to achieve the magnetron effect.

To minimize the pinching effect, the magnetic shunt 18 should be magnetically unsaturated during the entire sputtering operation. That is, the shunt 18 must be capable of absorbing all, or nearly all, of the excess magnetic flux expected to be liberated from the target. Since it is usually desirable to erode nearly the entire thickness of the target 14, the magnetic shunt 18 should be capable of absorbing all of the magnetic flux that is carried by the target 14. That is:

$$M_{S_{target}} \, t_{target} \; \approx \; M_{S_{shunt}} \, t_{shunt} \qquad\qquad (2)$$

To minimize the thickness 40 of the shunt 18, it is usually desirable to fabricate the shunt from a material having a high magnetic saturation, such as soft iron. In that case, the saturation magnetization of the shunt is known, and the thickness 40 of the shunt 18 is then given approximately by the following equation:

$$t_{shunt} \; \approx \; \frac{M_{S_{target}} t_{target}}{M_{S_{shunt}}} \qquad\qquad (3)$$

When such materials are used, shunt thicknesses in the range of about 0.3 cm (0.12 in) are generally sufficient to ensure that the shunt will be capable of absorbing all of the magnetic flux expected to be liberated from the target 14. The shunt 18 must be placed relatively close to the back surface 22 of target 14, but not in contact with the back surface. When sputtering relatively hard magnetic materials, such as cobalt and its alloys, it has been found that the gap 36 should be between about 0.025 cm and 0.200 cm (0.010 - 0.080 in), with the preferred gap width 36 being about 0.050 cm (0.020 in). However, as will be described below, the gap 36 may need to be larger when sputtering soft magnetic materials.

The ratio of shunt width to gap width is also important in achieving the objects of the invention. Good results can be obtained when the width 34 of shunt 18 is between about 10 to 90 times (wherein the range of above 40 is not claimed) the width of gap 36, with the best results being obtained when the shunt width is about 30 to 40 times the gap width.

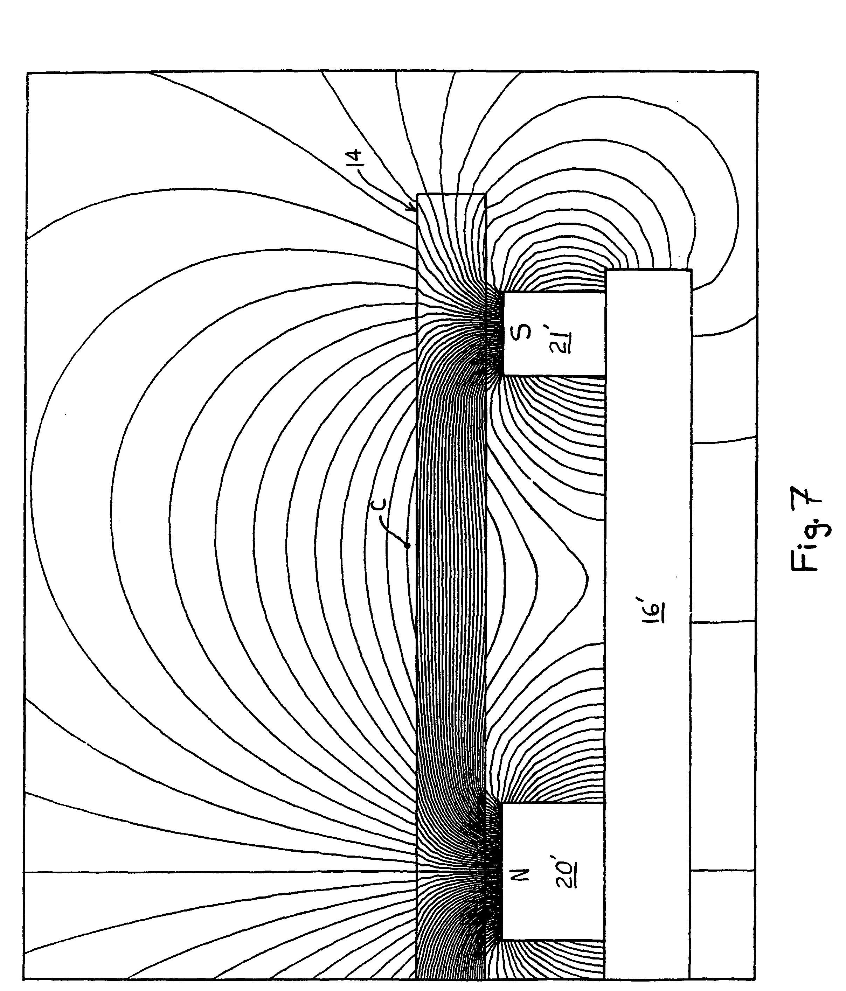

While the objects of the invention can be achieved by providing a magnet structure and shunt substantially as shown and described above, the magnetron assembly can often be optimized by using one of the many commercially available computer modeling programs to refine the proposed configuration. The first step in optimizing the design is to select a magnet assembly and target material to be sputtered. The computer program can then be used to plot the resulting magnetic field. See Figure 7. For best results, the magnetic field should be "balanced," i.e., the central axis C of the magnetic tunnel should be located about midway between the respective central magnets 20 and 20' and the outer magnets 21 and 21'. The field should also be reasonably symmetrical on either side of the central axis C, as best seen in Figure 7. If the magnet and target assembly do not initially produce such a magnetic field configuration, then the relative sizes and/or strengths and/or positions of the magnets should be changed and the new configuration remodeled until a field configuration substantially as shown in Figure 7 is produced.

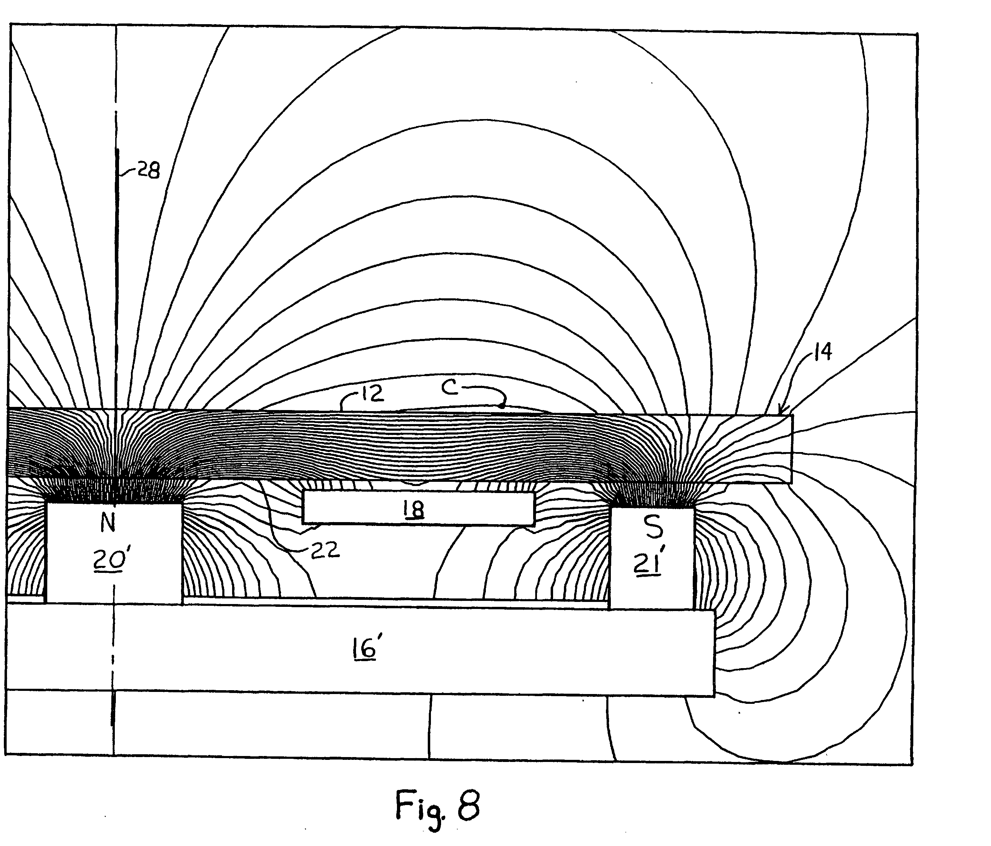

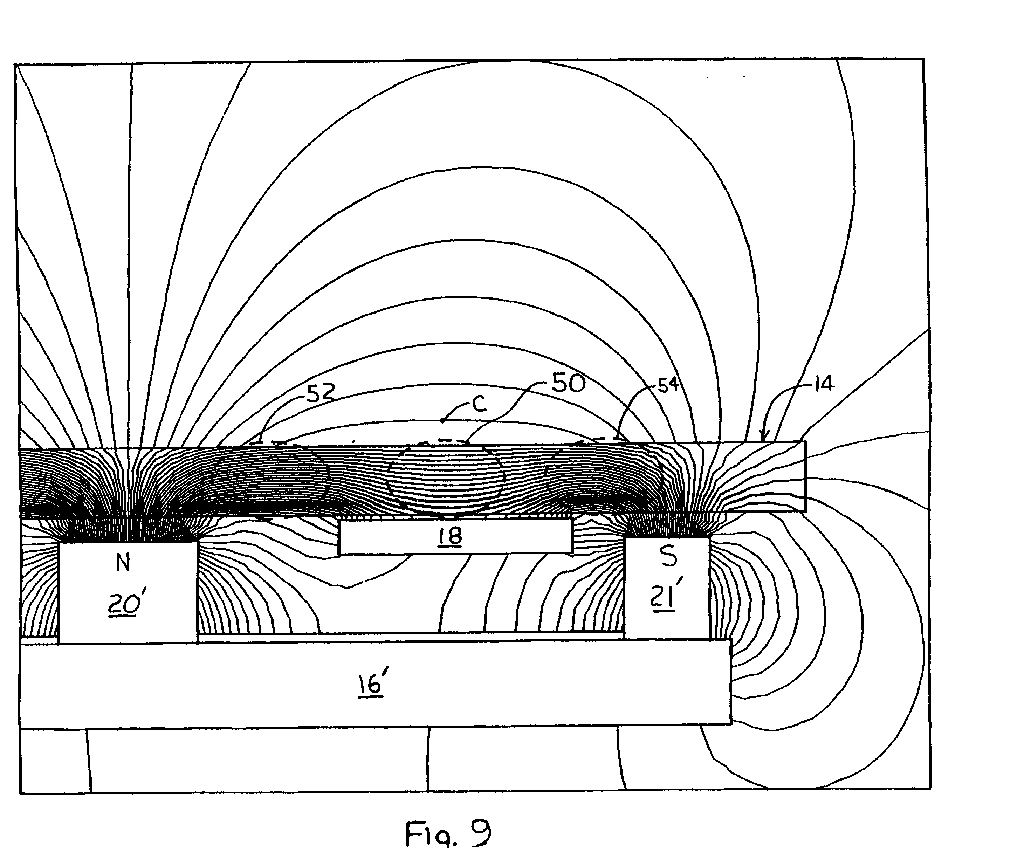

After the magnet and target assembly is balanced, a magnetic shunt having the desired thickness 40 and width 34 (Fig. 4) is then added to the model and the field shape re-computed. See Figure 8. For best results, the region defined by the magnetic flux lines that are substantially parallel to the front surface 12 of target 14 must be made as large as possible. Normally, it will be possible to position the shunt 18 so that the magnetic flux lines are substantially parallel to the front surface of the target over a range of about 30%-50% of the usable target surface, i.e., that portion of the target that extends from the axis of symmetry 28' to the outer magnets 21'. In the embodiment shown in Figure 8, it was necessary to move the shunt 18 approximately 2 mm (0.08 in) to the right and about 0.5 mm (0.2 in) closer to the back surface 22 of target 14 in order to maximize the region within which the magnetic flux lines were substantially parallel to the front surface of the target. The resulting configuration is shown in Figure 9.

As described above, any inflection points or dips in the magnetic field, such as taught by Welty, must be avoided. The magnetic flux lines must be as flat as possible and nearly parallel to the front surface of the target. Dips or curves in the magnetic field will result in deep, spike-like erosion grooves with little or no sputtering occurring elsewhere.

When sputtering hard magnetic materials, such as cobalt and its alloys, the shunt 18 also has the effect of reducing the strength of the magnetic field within the target body in the region 50 next to the shunt, which reduction is also important in achieving the objects of the invention. In the embodiment shown in Figure 9, the strength of the magnetic field in region 50 is only about 40% to 60% of the strength of the field in regions 52 and 54.

By way of example, the methods and equations described above were used to come up with the following dimensional parameters for the target 14 and magnetic shunt 18:

| Target Material | Cobalt Alloy |
| --- | --- |
| Saturation Magnetization of Target Material | $\sim$6,000 gauss/cm$^2$ |
| Target Width | 12.7 cm |
| Target Thickness | 0.80 cm |
| Shunt Material | soft iron |
| Saturation Magnetization of Shunt Material | $\sim$21,000 gauss/cm$^2$ |
| Shunt Width | 2.0 cm |
| Shunt Thickness | 0.318 cm |
| Gap Between Shunt and Target | 0.050 cm |

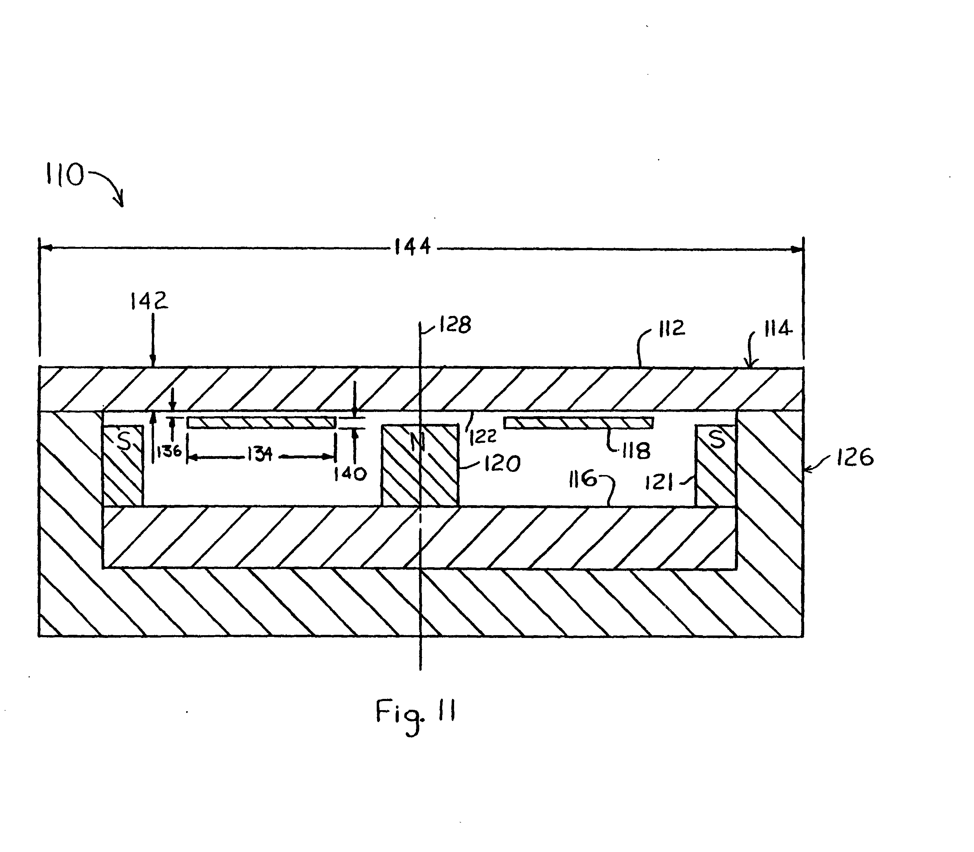

The sputtering magnet assembly according to this invention can also be configured for use with circular, as opposed to rectangular, targets. Referring now to Figures 10 and 11, the sputtering magnet assembly 110 is specifically configured to generate a ring-shaped magnetic tunnel for sputtering a plate-like circular target of cobalt alloy having a mean diameter 144 of about 12.7 cm (5 in) and a mean thickness 142 of about 0.60 cm (0.25 in). Since the magnet assembly 110 is specifically configured to sputter a circular target, base pole piece 116 is also circular and is constructed from a magnetically permeable material, such as Permalloy, iron, or nickel, to minimize magnetic losses. The individual magnets 120 and 121 are likewise arranged in a circular manner directly on the base pole piece 116, as best seen in Figure 10. As was the case for the semi-circular end sections 17 of the first embodiment 10, the cylindrical central magnet 120 is mounted to the center of base pole piece 116, concentric with axis of symmetry 128 of target 114, and is oriented so that its north pole N is immediately adjacent the back surface 122 of target 114. A plurality of outer magnets 121 are mounted to the outer periphery of base pole piece 116 and have magnetic orientations opposite the central magnet 120, i.e., the south poles S of the outer magnets 121 are immediately adjacent the back surface 122 of target 114. In the embodiment shown in Figures 10-14, the central magnet 120 is 9.5 mm high and has a diameter of 32 mm, while the outer magnets 121 are each 9.5 mm high and 8 mm wide.

A magnetic shunt 118 in the form of a flat ring has a width 134 and a thickness 140 and is positioned between the central magnet 120 and the outer magnets 121, as best seen in Figures 10 and 11. Shunt 118 is positioned adjacent the back surface 122 of target 114, so that a gap 136 exists between the shunt 118 and the back surface 122 of target 114. As was the case for the first embodiment 10 for sputtering rectangular targets, the second embodiment 110 for sputtering circular targets can be optimized by using a computer modeling program to refine the proposed configuration.

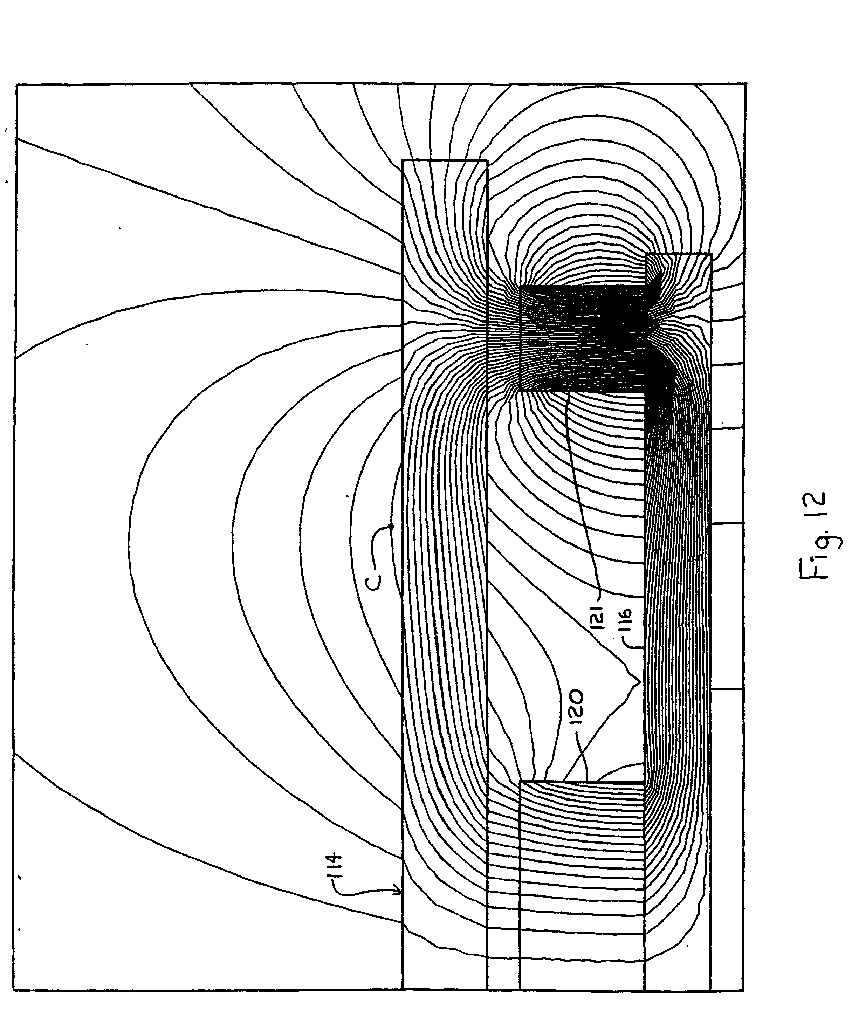

As shown in Figure 12, the proposed configuration was first modeled without the presence of a magnetic shunt 118 to balance the magnetic field. In the first embodiment, the central axis C of the magnetic tunnel was located approximately midway between the central magnet and the outer magnets.

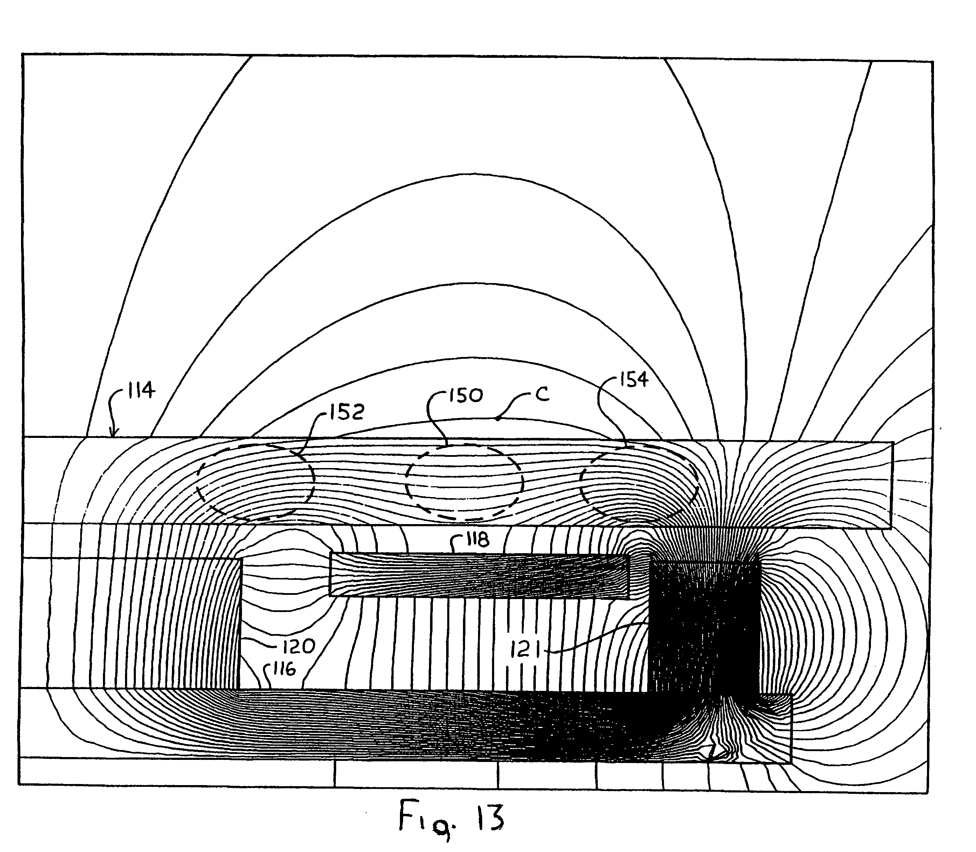

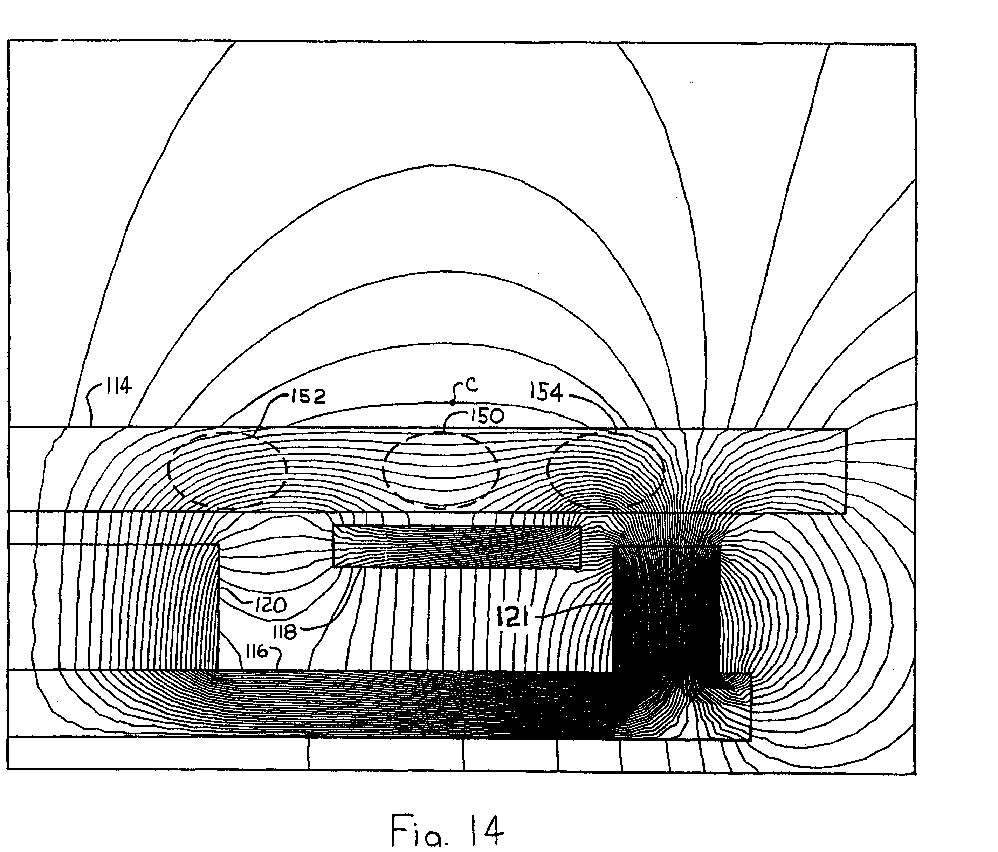

A magnetic shunt 118 22 mm (0.87 in) wide and 3.2 mm (0.13 in) thick was then centered approximately below central axis C and positioned 2 mm (0.08 in) from the back surface 122 of target 114. The field shape was then re-computed, as shown in Figure 13. While the field lines shown in Figure 13 are relatively flat over a large portion of the useable target surface, it is also important that the strength of the field in the region 150 next to the shunt be lower than the strength of the field in regions 152 and 154, as described above. In the configuration shown in Figure 13, that reduction is not great enough to produce the best results. Consequently, the configuration and positioning of the shunt 118 was changed slightly to produce a greater reduction in the strength of the magnetic field in region 150. The final configuration is shown in Figure 14, wherein the gap width was reduced to 1 mm (0.04 in) and the width of the shunt reduced to 20 mm (0.79 in).

The optimized magnetron assembly shown in Figure 14 has the following dimensional parameters:

| Target Material | Cobalt Alloy |
| --- | --- |
| Saturation Magnetization of Target Material | $\sim$6,000 gauss/cm$^2$ |
| Target Diameter | 12.7 cm |
| Target Thickness | 0.60 cm |
| Shunt Material | soft iron |
| Saturation Magnetization of Shunt Material | $\sim$21,000 gauss/cm$^2$ |
| Shunt Width | 2.0 cm |

(continued)

| Target Material | Cobalt Alloy |
|---|---|
| Shunt Thickness | 0.32 cm |
| Gap Between Shunt and Target | 0.1 cm |

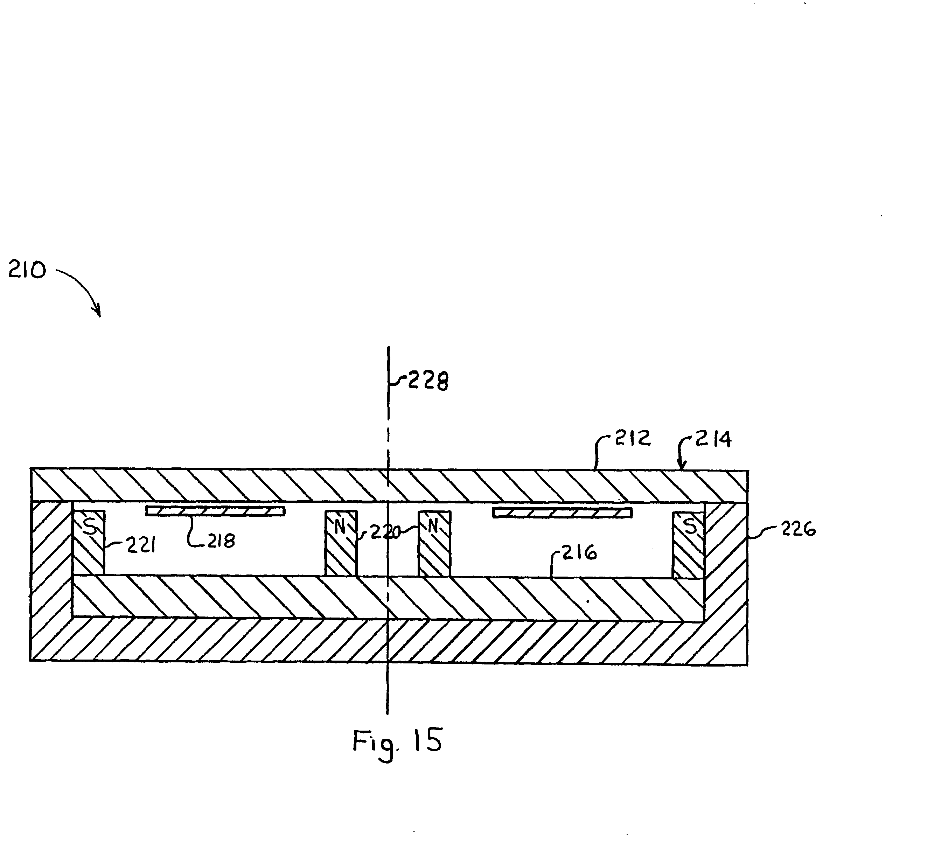

A third embodiment 210 of a sputtering magnet assembly is shown in Figure 15. The third embodiment is preferred when sputtering rectangular targets wider than about 12.7 cm (5 in) or circular targets having diameters greater than about 12.7 cm (5 in). Essentially the third embodiment 210 is identical to the first and second embodiments 10 and 110, except that the cylindrical central magnets 20 (used in the semi-circular end sections of the first embodiment 10, or as the single center magnet of the second embodiment 110) are replaced with a plurality of smaller magnets 220 arranged in a circle about axis of symmetry 228. Replacing the cylindrical magnet with a plurality of smaller magnets 220 makes it easier to balance the resulting magnetic field and reduces magnetic field distortion resulting from excessively high flux levels in the target material near the center of the cylindrical central magnet.

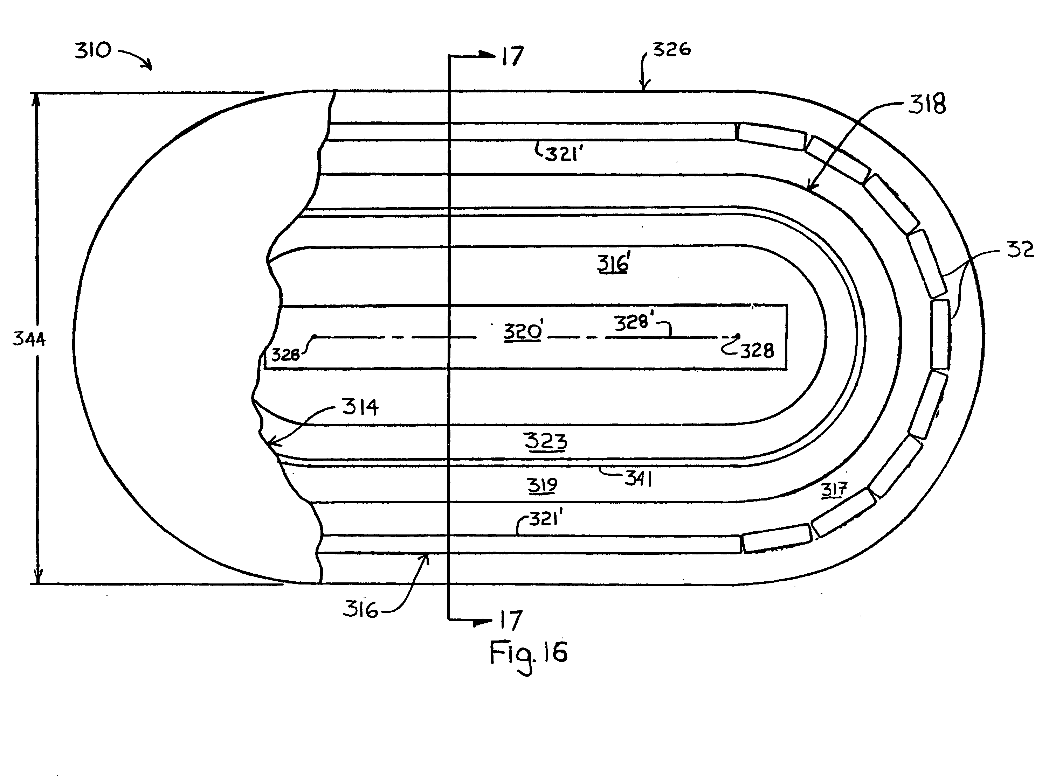

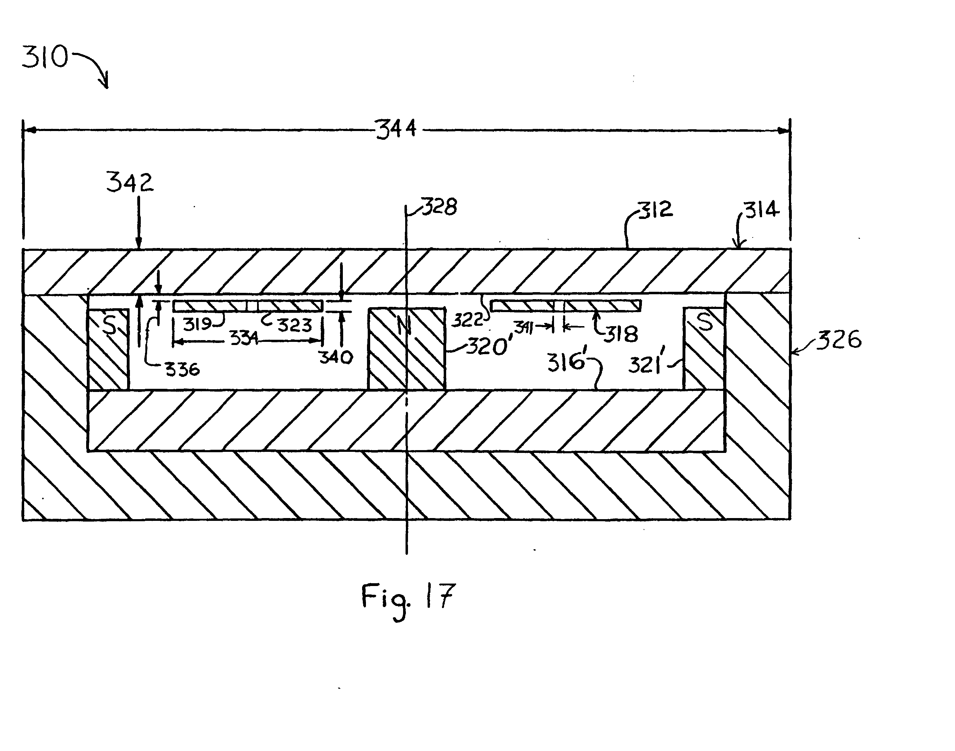

White the foregoing embodiments work well for sputtering relatively "hard" magnetic target materials, such as cobalt and its alloys, better results can be obtained when sputtering soft magnetic target materials, such as iron or nickel, by using a two piece or split shunt assembly 318 as shown in Figures 16 and 17.

The split shunt sputtering magnet assembly 310 is configured to generate a racetrack-shaped magnetic tunnel for sputtering a magnetically soft rectangular target 314 of nickel alloy having a mean width 344 of about 12.7 cm (5 in) and a mean thickness 342 of about 0.63 cm (0.25 in). As was the case for the magnet assembly 10 shown in Figures 4 and 5, the magnet assembly 310 is specifically configured to sputter a rectangular target and includes a base pole piece 316 in the shape of a flattened oval and constructed from a magnetically permeable material, such as Permalloy, iron, or nickel, to minimize magnetic losses. The individual magnets 320', 321, and 321' are likewise arranged in the shape of a flattened oval directly on the base pole piece 16, as best seen in Figure 16. Note that unlike the embodiments shown in Figures 4 and 5, the embodiment shown in Figure 16 does not include any cylindrical central magnets. It has been found that when sputtering magnetically soft materials, the presence of a cylindrical magnet disrupts the shape of the magnetic tunnel near each semi-circular end section, thus resulting in uneven sputtering. Consequently, it is sufficient when sputtering soft magnetic materials to align the elongated central magnet 320' with a longitudinal axis 328' with the ends extending about to the positions shown in Figure 16. A plurality of outer magnets 321 and 321' are mounted to the outer periphery of base pole piece 316 and have magnetic orientations opposite the central magnet 320', i.e., the south poles S of the outer magnets 321 and 321' are immediately adjacent the back surface 322 of target 314, as best seen in Figure 17. In the preferred embodiment 310, the elongated central magnet 320' is 9.5 film high, 13 mm wide, and sufficiently long to extend just beyond the axes of symmetry 328 of each semi-circular end section 317, as best seen in Figure 16. The outer magnets 321 are each 9.5 mm high and 8 mm wide, while the two elongated outer magnets 321' are each 9.5 mmm high, 8 mm wide, and sufficiently long to extend between the outer magnets 321 at each semi-circular end section 317. Alternatively, and as would be obvious to persons having ordinary skill in the art, a plurality of smaller magnets, arranged end-to-end, could be substituted for the single elongated central magnet 320' or for each of the single elongated outer magnets 321'. All magnets are rare earth Neodymium Iron Boron (NdFeB) and have magnetic field energy products of at least 35 megagauss-oersted (MGOe).

The two piece shunt assembly 318 can be considered to be a single piece shunt but with a portion of the center removed, thus forming an inner shunt 323 and an outer shunt 319 separated by a shunt gap 341. An initial determination of the overall shunt width 334, shunt thickness 340 as well as the size of gap 336 can be determined by the process described above for a single piece shunt, with a few differences. For example, the gap width 336 may need to be increased somewhat when sputtering soft magnetic materials, and it has been found that the width of gap 336 should be between about 0.100 cm and 0.400 cm (0.04 - 0.16 in), with the preferred width of gap 336 being about 0.300 cm (0.12 in). Also, the ratio of overall shunt width 334 to gap thickness 336 should be in the range of about 5:1 to 30:1, with the preferred ratio being about 7:1.

Once these initial dimensions have been determined, a shunt gap 341 is selected which effectively divides the shunt into two portions 323 and 319. Since the size of the shunt gap 341 is a function of the configuration of the magnet assembly 310 as well as the material used as the target 314, it has been found that the best method for determining the size and location of the shunt gap 341 is to first select a shunt gap in the range of about 0.05 cm and 0.5 cm (0.02 - 0.20 in) and then refine the size and location of the gap 341 based on the results of the computer modeling process described below. If it is not possible to so model the configuration, a shunt gap 341 of about 0.2 cm (0.08 in) positioned about in the center of the shunt will provide satisfactory results.

The first step in optimizing the design is to select a magnet assembly and target material to be sputtered. The resulting configuration, which does not yet include a shunt assembly 318, is then modeled to determine whether any changes need to be made to the magnet assembly to balance the magnetic field, i.e., make the magnetic field symmetrical and approximately centered between the central and outer magnets.

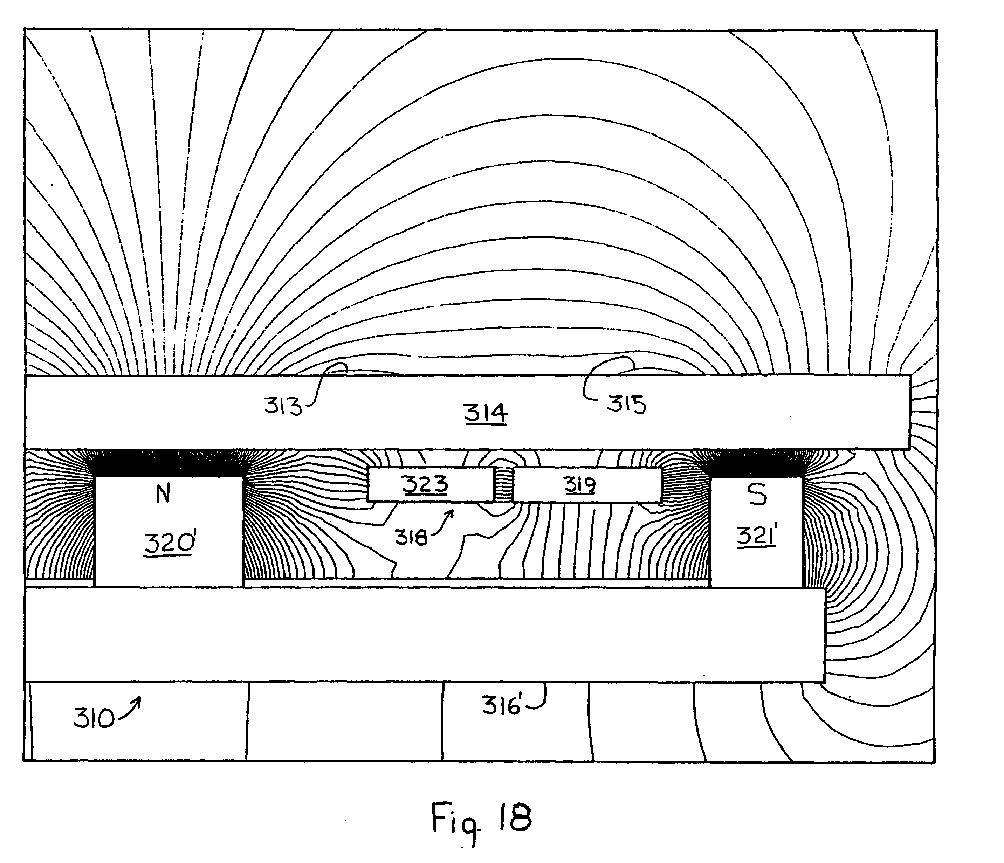

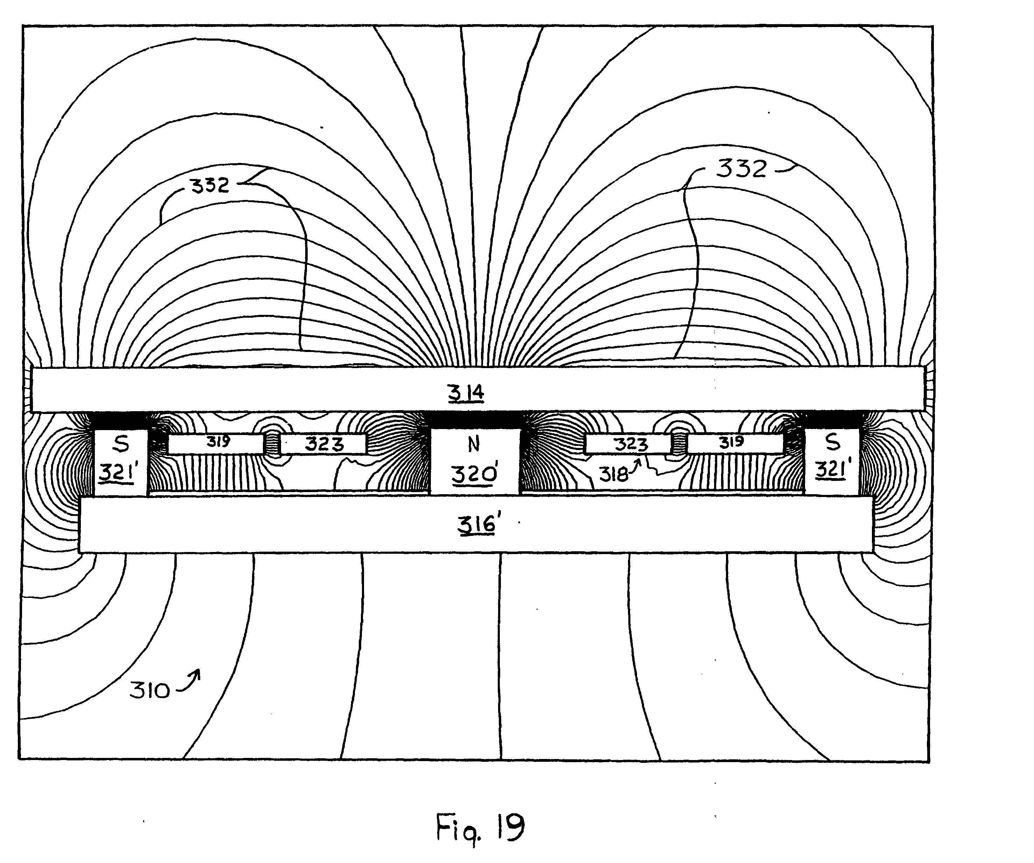

A two piece magnetic shunt assembly 318 is then inserted and the magnet and shunt assembly remodeled to determine the shape of the resulting magnetic field. A good initial configuration can be obtained by using the above described method to come up with the appropriate dimensions for a single shunt. A gap in the range specified above can then be inserted at about the center of the shunt to divide the shunt assembly 318 into an inner shunt 323 and an outer shunt 319, as best seen in Figures 16 and 17. For example, in the embodiment 310 having a nickel alloy target, the foregoing method was used to define a shunt having an initial overall width 334 of 28.5 mm (1.12 in) and an initial overall thickness 340 of 3.2 mm (0.13 in). The shunt was then made into two pieces by inserting a 1.5 mm (0.06 in) gap substantially in the middle of the shunt. The resulting two piece shunt assembly 318 was then centered approximately midway between the central magnet 320' and the outer magnet 321' and positioned 1.5 mm (0.06 in) from the back surface 322 of target 314. The magnetic field shape produced by the initial two piece shunt configuration is shown in Figure 18. While the field lines shown in Figure 18 are relatively flat over most of the front surface 312 of target 314, the field does include two inflection points 313 and 315 near the central and outer magnets 320' and 321' that could result in an uneven erosion pattern having two deep, spike-like erosion grooves. Consequently, the configuration and positioning of the two piece shunt assembly 318 was changed slightly to reduce or eliminate the inflection points 313 and 315. The final configuration is shown in Figure 19, wherein the gap 336 between the shunts and the back surface 322 of the target 314 was increased from 1.5 mm (0.06 in) to 3.0 mm (0.12 in) and the shunt gap 341 was increased from 1.5 mm (0.06 in) to 2.0 mm (0.08 in).

The optimized magnetron assembly shown in Figure 19 has the following dimensional parameters:

| Target Material | Nickel Alloy |
|---|---|
| Target Width | 12.7 cm |
| Target Thickness | 0.63 cm |
| Shunt Material | soft iron |
| Saturation Magnetization of Shunt Material | $\sim$21,000 gauss/cm$^2$ |
| Overall Shunt Width | 2.85 cm |
| Width of Inner Shunt | 1.25 cm |
| Width of Outer Shunt | 1.40 cm |
| Shunt gap | 0.20 cm |
| Shunt Thickness | 0.32 cm |
| Gap Between Shunt and Target | 0.3 cm |

It should be noted that when optimizing a magnet assembly for sputtering magnetically soft targets, such as magnet assembly 310, it is still desirable to configure the magnet assembly so that the resulting magnetic field comprises flux lines that are substantially parallel to the front surface of the target over as large a region as possible. Generally speaking, it will be possible to optimize the configuration of the magnet and two piece shunt assembly so that the magnetic flux lines are substantially parallel to the front surface of the target over a range of about 30% to 50% of the useable target surface, i.e., that portion of the target surface that extends from the axis of symmetry 328 to the outer magnets 321'.

Further, any inflection points or dips in the field must be minimized or eliminated to minimize or eliminate uneven target erosion. While the flux lines 332 shown in Figure 19 do exhibit some waviness, the magnitude of that waviness is considerably less than that shown in Figure 18, and will not adversely affect the target erosion pattern. That is, persons having ordinary skill in the art will recognize that it will always be possible to discover some degree of waviness in the field lines if the plotting parameters of the computer program are adjusted to produce field lines at close intervals. However, the presence of minor amounts of waviness in the field lines will not adversely affect the performance of the invention.

Also, while the two piece shunt assembly 318 of magnet assembly 310 has the effect of reducing the strength of the magnetic field within the target body, as was described above for magnetically hard target materials, the ease with which magnetically soft targets, such as iron and nickel, can be saturated makes the reduction in field strength within the body of magnetically soft target bodies considerably less pronounced. Therefore, when sputtering targets made from magnetically soft targets, it may not be possible to achieve the same amount of magnetic field strength reduction that is possible for harder magnetic materials, such as the cobalt alloy described above and shown in Figure 9.

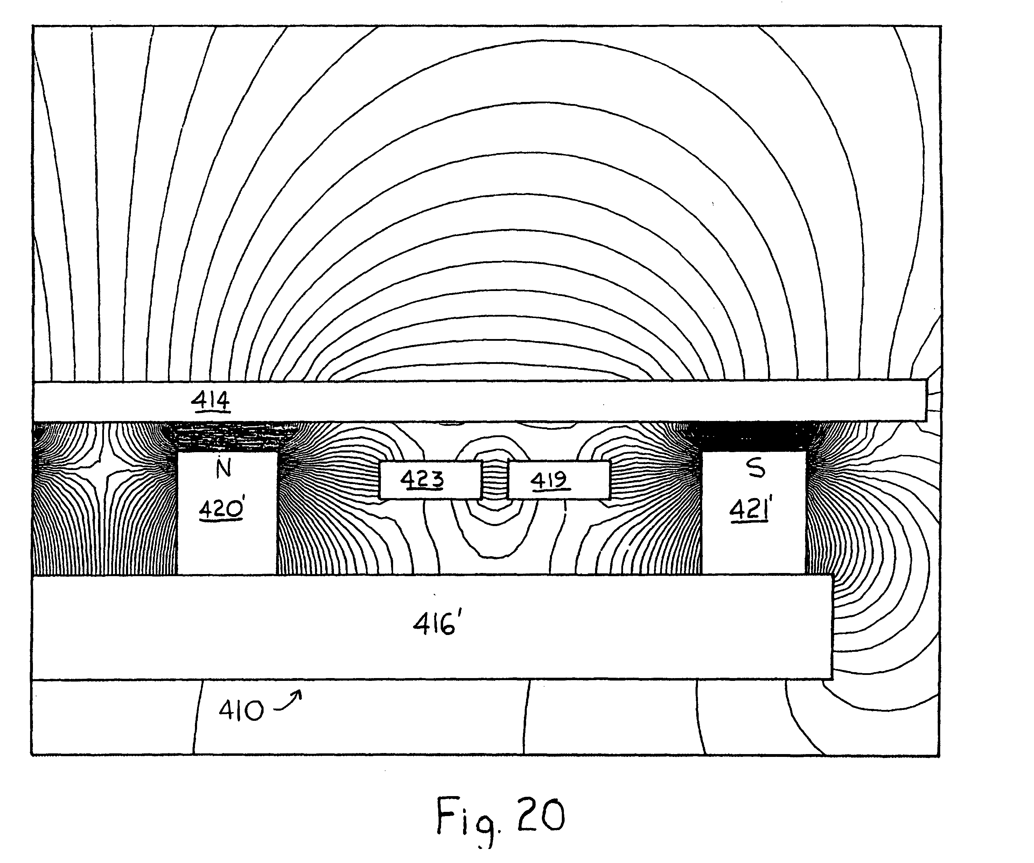

Another embodiment 410 for sputtering a magnetically soft iron alloy target is shown in Figure 20. Like the third embodiment 210 shown in 14, the embodiment 410 shown in Figure 20 is preferred when sputtering rectangular targets wider than about 12.7 cm (5 in). Alternatively, the configuration shown in Figure 20 could be used with circular targets having diameters greater than about 12.7 cm (5 in). The embodiment shown in Figure 20 for sputtering rectangular targets is essentially identical to the third embodiment 210 and all the magnets are 9.5 mm high and 8 mm wide and have magnetic field energy products of 37-40 megagauss-oersted (MGOe).

The optimized magnetron assembly shown in Figure 20 has the following dimensional parameters:

| Target Material | Iron Alloy |
|---|---|
| Target Width | 12.7 cm |
| Target Thickness | 0.30 cm |
| Shunt Material | soft iron |
| Saturation Magnetization of Shunt Material | $\sim$21,000 gauss/cm$^2$ |
| Overall Shunt Width | 1.80 cm |
| Width of Inner Shunt | 0.80 cm |
| Width of Outer Shunt | 0.80 cm |
| Shunt gap | 0.20 cm |
| Shunt Thickness | 0.30 cm |
| Gap Between Shunt and Target | 0.30 cm |

This completes the detailed description of the preferred embodiments of the sputtering magnet assembly 10 according to the present invention. While a number of specific components were described above for the preferred embodiments of this invention, persons skilled in this art will readily recognize that other substitute components or combinations of components may be available now or in the future to accomplish comparable functions to sputtering magnetron apparatus according to this invention. For example, numerous target materials and sizes may be sputtered according to the present invention, and the above-described method for calculating the relative sizes and configurations of the target material and magnetic shunt can be used for most common target sizes. Likewise, myriad configurations for the plasma-confining magnetic field are possible and the magnetic shunt could be used with such other field configurations, provided the magnetic shunt is configured to provide a lower energy pathway for the excess magnetic flux. Accordingly, and the present invention should not be regarded as limited to the particular target and magnetic field configurations shown and described herein.

Other possible substitutes have been mentioned throughout this description, and, many more equivalents are possible. For example, the magnet assembly 10 according to the present invention is not limited to permanent magnets and an equivalent alternative would be to use electromagnets, or a combination of electromagnets and permanent magnets, such as disclosed by Boys *et al.* or Abe *et al.* Therefore, it would be feasible to someone having ordinary skill in the art, in light of this disclosure, to assemble the necessary components to practice this invention, regardless of whether some of such components might not be the same as those described herein.

Consequently, the foregoing is considered illustrative only of the principles of the invention. Further, since numerous modifications and changes will readily occur to those skilled in the art, it is not desired to limit the invention to the exact construction and operation shown and described, and accordingly, all suitable modifications and equivalents may be resorted to as falling within the scope of the invention as defined by the claims which follow.

**Claims**

**1.**    A magnetron sputtering apparatus, comprising a magnet assembly (10, 110, 210) and a magnetic target (14, 114), the target (14, 114) having a saturation magnetization, a front surface (12), a body and a back surface (22, 122), said magnet assembly (10, 110, 210) being positioned adjacent the back surface (22, 122) of the target (14, 114) and generating a magnetic field having sufficient strength to produce a plasma confining magnetic tunnel (24) over the front surface (12) of the target (14, 114), said magnetic field being **characterized by** magnetic flux, some of which is interior to the target and some of which is exterior to the target and defines a sputtering region (30) adjacent to the front surface (12) of the target, said magnet assembly also including a magnetic shunt (18, 118) having a saturation magnetization and a width, said magnetic shunt (18, 118) being positioned a spaced distance (36) from the back surface (22, 122) of the target to provide an alternate path for excess magnetic flux liberated by erosion of the target, the alternate path having less magnetic resistance than paths exiting the front surface (12) of the target (14, 114) into the sputtering region (30) and back into the front surface of the target, whereby most of said excess magnetic flux is prevented from exiting the front surface of the target into the sputtering region and back into the target as the front surface of the target erodes by sputtering, **characterized in that** said magnetic shunt (18, 118) has a thickness (40) to absorb all of the excess magnetic flux liberated by the erosion of the target (14, 114), and that the width (34) of said magnetic shunt (18) is in the range of 10 - 40 times the width of the space distance (36) between said magnetic shunt (18) and the back surface (22) of the target (14).

2. The magnet assembly of claim 1, wherein the spaced distance (36) between said magnetic shunt (18) and the back surface (22) of the target (14) is in the range of 0.025 cm to 0.200 cm.

3. The magnet assembly of claim 1, wherein the target (114) is circular and has an axis of symmetry (128) and wherein said magnetic shunt (118) comprises a circular ring concentric with the axis of symmetry of the circular target (114).

4. The magnet assembly of claim 3, further comprising:

a circular magnetically permeable base pole piece (116) having an axis of symmetry aligned with the axis of symmetry (128) of the circular target (114) and substantially parallel to the back surface (122) of the target; a central magnet (120) mounted to the center of said base pole piece (116) having a north-south magnetic orientation that is substantially perpendicular tot he back surface (122) of the target; an outer magnet (121) mounted to the outer periphery of said base pole piece (116), concentric with said central magnet (120) and said magnetic shunt (118), said outer magnet (121) being positioned so that said magnetic shunt (118) is substantially between said outer magnet (121) and said central magnet (120), said outer magnet (121) having a north-south magnetic orientation that is substantially perpendicular to the back surface (122) of the target (114) and opposite the magnetic orientation of said central magnet (120).

5. The magnet assembly of claim 1, wherein the target (14) is rectangular and includes a longitudinal axis and a transverse axis, said magnet assembly (10) including a linear center section (21') and two end sections (17), said linear section being aligned with the longitudinal axis of the target (14), and wherein said magnetic shunt (18) comprises two substantially linear sections disposed in parallel, spaced-apart relation on opposite sides of the longitudinal axis of the rectangular target, the respective parallel linear sections of said magnetic shunt (18) being joined at either end by respective substantially semi-circular end sections.

6. The magnet assembly of claim 5, further comprising:

an elongated magnetically permeable base pole piece (16) having an elongated center section (16') and two semi-circular end sections, the elongated center section (16') of said base pole piece (16) being aligned with the longitudinal axis of the rectangular target (14) and substantially parallel to the back surface (12) of the rectangular target; a central magnet assembly (20') mounted to the center of said base pole piece (16), said central magnet assembly including an elongated center magnet (20') that is aligned with the longitudinal axis of the rectangular target (14), a first cylindrical magnet (20) disposed at one end of said elongated center magnet (20'), and a second cylindrical magnet (20) disposed at the other end of said elongated center magnet (20'), said elongated center magnet and said firs and second cylindrical magnets having north-south magnetic orientations that are substantially perpendicular to the back surface (22) of the target (14); a plurality of outer magnets (21, 21') mounted to the outer periphery of said base pole piece (16), each of said outer magnets being substantially equidistant from said central magnet assembly (20, 20') and said magnetic shunt (18), and wherein each of said outer magnets (21, 21') has a north-south magnetic orientation that is substantially perpendicular to the back surface of the target (14) and opposite the magnetic orientation of said central magnet assembly.

7. An assembly of a magnetron sputtering cathode and a magnetic target, the target (14, 114) having a front surface (12), a body, and a back surface (22, 122), said magnetron sputtering cathode comprising:

a generally plate-shaped pole piece (16, 116) defining a plane and comprising a magnetically permeable material; first magnet means (20, 20', 120, 220) positioned on said pole piece and having a north-south magnetic orientation that is substantially perpendicular to said plane; second magnet means (21, 21', 121) positioned on said pole piece at a spaced distance from said first magnet means and having a north-south magnetic orientation that is substantially perpendicular to said plane and substantially opposite the magnetic orientation of said first magnet means, said first and second magnet means being spaced to produce a magnetic field having a strength sufficient to produce a plasma-confining magnetic tunnel over the front surface of the target, the magnetic field being **characterized by** magnetic flux, some of which is interior to the target and some of which is exterior to the target and defines a sputtering region adjacent the front surface of the target; and

magnetic shunt means (18, 118) comprising a magnetic permeable material having a width and positioned between said first magnet means and said second magnet means, substantially parallel to said plane and closely adjacent the back surface (22) of the target so that a gap (36) exists between said magnetic shunt means and the back surface of the target, said magnetic shunt means providing an alternate path for excess magnetic flux liberated by erosion of the target, the alternate path having less magnetic resistance than paths exiting the front surface of the target into the sputtering region and back into the front surface of the target, whereby most of said excess magnetic flux is prevented from exiting the front surface of the target into the sputtering region and back into the target as the front surface of the target erodes by sputtering, **characterized in that** said magnetic shunt means have a thickness to absorb all of the excess magnetic flux liberated by the erosion of the target, and that the width of said magnetically permeable material is in the range of 10-40 times the width of the gap between said magnetic shunt means and the back surface (22) of the target (14).

8. The magnetron sputtering cathode of claim 7, wherein the gap (36) between said magnetic shunt means and the back surface (22) of the target (14) is in the range of 0.025 cm to 0.400 cm.

9. The magnetron sputtering cathode of claim 7, wherein said magnetically permeable material is soft iron, Permalloy or nickel.

**Patentansprüche**

1. Magnetron-Sputtervorrichtung, mit einer Magnetanordnung (10, 110, 210) und einem Magnettarget (14, 114), wobei das Target (14, 114) eine Sättigungsmagnetisierung, eine Vorderfläche (12), einen Körper und eine Rückfläche (22, 122) hat, wobei die Magnetanordnung (10, 110, 210) benachbart der Rückfläche (12, 122) des Targets (14, 114) angeordnet ist und ein Magnetfeld erzeugt, das eine ausreichende Stärke hat, um einen ein Plasma eingrenzenden Magnettunnel (24) über die Vorderfläche (12) des Targets (14, 114) zu erzeugen, wobei das magnetische Feld durch magnetischen Fluß **gekennzeichnet** ist, von dem etwas innerhalb des Targets ist und etwas außerhalb des Targets ist und einen Sputterbereich (30) benachbart der Vorderfläche (12) des Targets definiert, wobei die Magnetanordnung auch einen magnetischen Shunt (18, 118) umfaßt, der eine Sättigungsmagnetisierung und eine Breite hat, wobei der magnetische Shunt (18, 118) in einem Abstand (36) von der Rückfläche (22, 122) des Targets positioniert ist, um einen alterriativen Weg für überschüssigen magnetischen Fluß zur Verfügung zu stellen, der durch Erosion des Targets freigesetzt wird, wobei der alternative Weg weniger magnetischen Widerstand hat als Wege, die aus der Vorderfläche (12) des Targets (14, 114) in den Sputterbereich (30) und zurück in die Vorderfläche des Targets austreten, wodurch verhindert wird, daß das meiste des überschüssigen magnetischen Flusses aus der Vorderfläche des Targets in den Sputterbereich und zurück in das Target austritt, wenn die Vorderfläche des Targets durch Sputtern erodiert, **dadurch gekennzeichnet, daß** der magnetische Shunt (18, 118) eine Dicke (40) hat, um all den überschüssigen magnetischen Fluß zu absorbieren, der durch die Erosion des Targets (14, 114) freigesetzt wird, und daß die Breite (34) des magnetischen Shunts (18) in dem Bereich von 10 bis 40 mal der Breite des Abstandes (36) zwischen dem magnetischen Shunt (18) und der Rückfläche (22) des Targest (14) ist.

2. Magnetanordnung nach Anspruch 1, bei der der Abstand (36) zwischen dem magnetischen Shunt (18) und der Rückfläche (22) des Targets (14) in dem Bereich von 0.025 cm bis 0.200 cm ist.

3. Magnetanordnung nach Anspruch 1, bei der das Target (114) kreisförmig ist und eine Symmetrieachse (128) hat und bei der der magnetische Shunt (118) einen kreisförmigen Ring aufweist, der konzentrisch zu der Symmetrieachse des kreisförmigen Targets (114) liegt.

4. Magnetanordnung nach Anspruch 3, die weiter aufweist:

ein kreisförmiges magnetisch permeables Basispolstück (116) mit einer Symmetrieachse, die mit der Symmetrieachse (128) des kreisförmigen Targets (114) ausgerichtet ist und im wesentlichen parallel zu der Rückfläche (122) des Targets liegt;

einen zentralen Magneten (120), der am Zentrum des Basispolstückes (116) angebracht ist, der eine magnetische Nord-Süd-Ausrichtung hat, die im wesentlichen senkrecht zu der Rückfläche (122) des Targets ist;

einen äußeren Magneten (121), der am Außenumfang des Basispolstückes (116) angeordnet ist, konzentrisch zu dem zentralen Magneten (120) und dem magnetischen Shunt (118), wobei der äußere Magnet (121) so positioniert ist, daß der magnetische Shunt (118) im wesentlichen zwischen dem äußeren Magneten (121) und dem zentralen Magneten (120) liegt, wobei der äußere Magnet (121) eine magnetische Nord-Süd-Ausrichtung hat, die im wesentlichen senkrecht zu der Rückfläche (122) des Targets (144) und entgegengesetzt der magnetischen Ausrichtung des zentralen Magneten (120) ist.

5. Magnetanordnung nach Anspruch 1, bei der das Target (14) rechtwinklig ist und eine Längsachse und eine Querachse umfaßt, wobei die Magnetanordnung (10) einen linearen Mittelabschnitt (21') und zwei Endabschnitte (17) umfaßt, wobei der lineare Abschnitt mit der Längsachse des Targets (14) ausgerichtet ist, und bei der der magnetische Shunt (18) zwei im wesentlichen lineare Abschnitte aufweist, die parallel und beabstandet auf gegenüberliegenden Seiten der Längsachse des rechtwinkligen Targets angeordnet sind, wobei die jeweiligen parallelen linearen Abschnitte des magnetischen Shunts (18) an jedem Ende durch jeweilige im wesentlichen halbkreisförmige Endabschnitte verbunden sind.

6. Magnetanordnung nach Anspruch 5, die weiter aufweist:

ein längliches magnetisch permeables Basispolstück (16) mit einem länglichen Mittelabschnitt (16') und zwei halbkreisförmigen Endabschnitten, wobei der längliche Mittelabschnitt (16') des Basispolstücks (16) mit der Längsachse des rechtwinkligen Targets (14) ausgerichtet und im wesentlichen parallel zu der Rückfläche (12) des rechtwinkligen Targets ist;

eine zentrale Magnetanordnung (20'), die an dem Zentrum des Basispolstückes (16) angeordnet ist, wobei die zentrale Magnetanordnung einen länglichen Zentralmagneten (20') umfaßt, der mit der Längsachse des rechtwinkligen Targets (14) ausgerichet ist, einen ersten zylindrischen Magneten (20), der an einem Ende des länglichen Zentralmagneten (20') angeordnet ist, und einen zweiten zylindrischen Magneten (20), der an dem anderen Ende des länglichen Zentralmagneten (20') angeordnet ist, wobei der längliche Zentralmagnet und der erste und zweite zylindrische Magnet magnetische Nord-Süd-Ausrichtungen haben, die im wesentlichen senkrecht zu der Rückfläche (22) des Targets (14) sind;

eine Vielzahl äußerer Magnete (21, 21'), die an dem Außenumfang des Basispolstückes (16) angeordnet sind, wobei jeder der äußeren Magnete im wesentlichen gleich beabstandet von der zentralen Magnetanordnung (20, 20') und dem magnetischen Shunt (18) ist und wobei jeder der äußeren Magnete (21, 21') eine magnetische Nord-Süd-Ausrichtung hat, die im wesentlichen senkrecht zu der Rückfläche des Targets (14) und entgegengesetzt zu der magnetischen Ausrichtung der zentralen Magnetanordnung ist.

7. Anordnung aus einer Magnetron-Sputterkathode und einem Magnettarget, wobei das Target (14, 114) eine Vorderfläche (12), einen Körper und eine Rückfläche (22, 122) hat, wobei die Magnetron-Sputterkathode aufweist:

ein im allgemeinen plattenförmiges Polstück (16, 116), das eine Ebene definiert und ein magnetisch permeables Material aufweist;

eine erste Magneteinrichtung (20, 20', 120, 220), das auf dem Polstück angeordnet ist und eine magnetische Nord-Süd-Ausrichtung hat, die im wesentlichen senkrecht zu der Ebene ist;

eine zweite Magneteinrichtung (21, 21', 121), die auf dem Polstück mit einem Abstand von der ersten Magneteinrichtung angeordnet ist, und eine magnetische Nord-Süd-Ausrichtung hat, die im wesentlichen senkrecht zu der Ebene und im wesentlichen entgegengesetzt zu der magnetischen Ausrichtung der ersten Magneteinrichtung ist, wobei die erste und die zweite Magneteinrichtung beabstandet sind, um ein Magnetfeld zu erzeugen, das eine ausreichende Stärke hat, um einen ein Plasma begrenzenden magnetischen Tunnel über die Vorderfläche des Targets zu erzeugen, wobei das magnetische Feld durch magnetischen Fluß **gekennzeichnet** ist, von dem etwas innerhalb des Targets ist und etwas außerhalb des Targets ist und einen Sputterbereich benachbart der Vorderfläche des Targets definiert; und

eine magnetische Shunteinrichtung (18, 118), welche magnetisch permeables Material aufweist, mit einer Breite und positioniert zwischen der ersten Magneteinrichtung und der zweiten Magneteinrichtung, im wesentlichen parallel zu der Ebene und eng benachbart der Rückfläche (22) des Targets, so daß ein Spalt (36) zwischen der magnetischen Shunteinrichtung und der Rückfläche des Targets vorliegt, wobei die magnetische Shunteinrichtung einen alternativen Weg für überschüssigen magnetischen Fluß zur Verfügung stellt, der durch die Erosion des Targets freigesetzt wird, wobei der alternative Weg weniger magnetischen Widerstand hat als Wege, die aus der Vorderfläche des Targets in den Sputterbereich und zurück in die Vorderfläche des Targets austreten, wodurch verhindert wird, daß das meiste des überschüssigen magnetischen Flusses aus der Vorderfläche des Targets in den Sputterbereich und zurück in das Target austritt, wenn die Vorderfläche des Targets durch Sputtern erodiert, **dadurch gekennzeichnet, daß** die magnetische Shunteinrichtung eine Dicke hat, um den gesamten überschüssigen magnetischen Fluß zu absorbieren, der durch die Erosion des Targets freigesetzt wird, und daß die Breite des magnetisch permeablen Materials in dem Bereich von 10 bis 40 mal der Breite des Spaltes zwischen der magnetischen Shunteinrichtung und der Rückfläche (22) des Targets (14) ist.

8. Magnetron-Sputterkathode nach Anspruch 7, bei der der Spalt (36) zwischen der magnetischen Shunteinrichtung und der Rückfläche (22) des Targets (14) in dem Bereich von 0.025 cm bis 0.400 cm ist.

9. Magnetron-Sputterkathode nach Anspruch 7, bei der das magnetisch permeable Material Weicheisen, Permalloy oder Nickel ist.


**Revendications**

1. Dispositif de pulvérisation à magnétron, comprenant un ensemble d'aimants (10, 110, 210) et une cible magnétique (14, 114), la cible (14, 114) ayant une aimantation à saturation, une surface frontale (12), un corps et une surface arrière (22, 122), ledit ensemble d'aimants (10, 110, 210) étant placé au voisinage immédiat de la surface arrière (22, 122) de la cible (14, 114) et générant un champ magnétique d'une intensité suffisante pour créer sur la surface frontale (12) de la cible (14, 114) un tunnel magnétique (24) de confinement de plasma, ledit champ magnétique étant **caractérisé par** un flux magnétique dont une partie est à l'intérieur de la cible et une partie est à l'extérieur de la cible et définit une région de pulvérisation (30) adjacente à la surface frontale (12) de la cible, ledit ensemble d'aimants comportant aussi un pont magnétique (18, 118) ayant une aimantation à saturation et une largeur, ledit pont magnétique (18, 118) étant espacé d'une certaine distance (36) par rapport à la surface arrière (22, 122) de la cible pour créer un trajet de remplacement pour l'excédent de flux magnétique libéré par érosion de la cible, le trajet de remplacement ayant une résistance magnétique inférieure à celle de trajets sortant de la surface frontale (12) de la cible (14, 114) pour entrer dans la région de pulvérisation (30) et revenir dans la surface frontale de la cible, grâce à quoi la majeure partie dudit excédent de flux magnétique est empêchée de sortir de la surface frontale de la cible pour entrer dans la région de pulvérisation et revenir dans la cible à mesure que la surface frontale de la cible s'érode du fait de la pulvérisation, **caractérisé en ce que** ledit pont magnétique (18, 118) a une épaisseur (40) permettant d'absorber la totalité de l'excédent de flux magnétique libéré par l'érosion de la cible (14, 114), et **en ce que** la largeur (34) dudit pont magnétique (18) est comprise entre 10 et 40 fois la largeur de la distance d'espacement (36) entre ledit pont magnétique (18) et la surface arrière (22) de la cible (14).

2. Ensemble d'aimants selon la revendication 1, dans lequel la distance d'espacement (36) entre ledit pont magnétique (18) et la surface arrière (22) de la cible (14) est comprise entre 0,025 cm et 0,200 cm.

3. Ensemble d'aimants selon la revendication 1, dans lequel la cible (114) est circulaire et a un axe de symétrie (128) et dans lequel ledit pont magnétique (118) comporte une couronne circulaire concentrique à l'axe de symétrie de la cible circulaire (114).

4. Ensemble d'aimants selon la revendication 3, comprenant en outre:

une pièce polaire de base circulaire (116) à perméabilité magnétique ayant un axe de symétrie aligné avec faxe de symétrie (128) de la cible circulaire (114) et sensiblement parallèle à la surface arrière (122) de la cible ;
un aimant central (120) monté au centre de ladite pièce polaire de base (116) ayant une orientation magnétique nord-sud sensiblement perpendiculaire à la surface arrière (122) de la cible ;
un aimant extérieur (121) monté sur le pourtour extérieur de ladite pièce polaire de base (116), concentrique audit aimant central (120) et audit pont magnétique (118), ledit aimant magnétique (121) étant placé de façon que ledit pont magnétique (118) soit sensiblement entre ledit aimant extérieur (121) et ledit aimant central (120), ledit aimant extérieur (121) ayant une orientation magnétique nord-sud sensiblement perpendiculaire à la surface arrière (122) de la cible (114) et opposée à l'orientation magnétique dudit aimant central (120).

**5.** Ensemble d'aimants selon la revendication 1, dans lequel la cible (14) est rectangulaire et comporte un axe longitudinal et un axe transversal, ledit ensemble d'aimants (10) comportant une partie centrale linéaire (21') et deux parties d'extrémités (17), ladite partie linéaire étant alignée avec l'axe longitudinal de la cible (14), et dans lequel ledit pont magnétique (18) comporte deux parties sensiblement linéaires disposées parallèlement, mutuellement opposées de part et d'autre de l'axe longitudinal de la cible rectangulaire, les parties linéaires parallèles respectives dudit pont magnétique (18) étant réunies à chaque extrémité par des parties d'extrémités respectives sensiblement semi-circulaires.

**6.** Ensemble d'aimants selon la revendication 5, comprenant en outre:

une pièce polaire de base allongée (16) à perméabilité magnétique ayant une partie centrale allongée (16') et deux parties d'extrémités semi-circulaires, la partie centrale allongée (16') de ladite pièce polaire de base (16) étant alignée avec l'axe longitudinal de la cible rectangulaire (14) et sensiblement parallèle à la surface arrière (12) de la cible rectangulaire ;

un ensemble d'aimants central (20') monté au centre de ladite pièce polaire de base (16), ledit ensemble d'aimants central comportant un aimant central allongé (20') aligné avec l'axe longitudinal de la cible rectangulaire (14), un premier aimant cylindrique (20) disposé à une première extrémité dudit aimant central allongé (20'), et un second aimant cylindrique (20) disposé à fautre extrémité dudit aimant central allongé (20'), ledit aimant central allongé et lesdits premier et second aimants cylindriques ayant une orientation magnétique nord-sud sensiblement perpendiculaire à la surface arrière (22) de la cible (14) ;

une pluralité d'aimants extérieurs (21, 21') montés sur le pourtour extérieur de ladite pièce polaire de base (16), chacun desdits aimants extérieurs étant sensiblement à égale distance dudit ensemble d'aimants central (20, 20') et dudit pont magnétique (18), et chacun desdits aimants extérieurs (21, 21') ayant une orientation magnétique nord-sud sensiblement perpendiculaire à la surface arrière de la cible (14) et opposée à (orientation magnétique dudit ensemble d'aimants central.

**7.** Ensemble composé d'une cathode de pulvérisation à magnétron et d'une cible magnétique, la cible (14, 114) ayant une surface frontale (12), un corps et une surface arrière (22, 122), ladite cathode de pulvérisation à magnétron comprenant:

une pièce polaire (16, 116) globalement en forme de plaque définissant un plan et constituée par une matière à perméabilité magnétique ;

des premiers moyens formant aimants (20, 20', 120, 220) placés sur ladite pièce polaire et ayant une orientation magnétique nord-sud sensiblement perpendiculaire audit plan ;

des seconds moyens formant aimants (21, 21', 121) placés sur ladite pièce polaire à distance desdits premiers moyens formant aimants et ayant une orientation magnétique nord-sud sensiblement perpendiculaire audit plan et sensiblement opposée à l'orientation magnétique desdits premiers moyens formant aimants, lesdits premiers et seconds moyens formant aimants étant espacés pour créer un champ magnétique dune intensité suffisante pour créer un tunnel magnétique de confinement de plasma sur la surface frontale de la cible, le champ magnétique étant **caractérisé par** un flux magnétique dont une partie est à l'intérieur de la cible et dont une partie est à l'extérieur de la cible et définissant une région de pulvérisation adjacente à la surface frontale de la cible ; et

un moyen formant pont magnétique (18, 118) en matière à perméabilité magnétique ayant une largeur et étant placé entre lesdits premiers moyens formant aimants et lesdits seconds moyens formant aimants, sensiblement parallèlement audit plan et au voisinage immédiat de la surface arrière (22) de la cible de façon qu'existe un espace (36) entre ledit moyen formant pont magnétique et la surface arrière de la cible, ledit moyen formant pont magnétique créant un trajet de remplacement pour l'excédent de flux magnétique libéré par érosion de la cible, le trajet de remplacement ayant une résistance magnétique inférieure à celle de trajets sortant de la surface frontale de la cible pour entrer dans la région de pulvérisation et revenir dans la surface frontale de la cible, grâce à quoi la majeure partie dudit excédent de flux magnétique est empêchée de sortir de la surface frontale de la cible pour entrer dans la région de pulvérisation et revenir dans la cible à mesure que la surface frontale de la cible s'érode du fait de la pulvérisation, **caractérisé en ce que** ledit moyen formant pont magnétique a une épaisseur permettant d'absorber la totalité de l'excédent de flux magnétique libéré par l'érosion de la cible, et **en ce que** la largeur de ladite matière à perméabilité magnétique est comprise entre 10 et 40 fois la largeur de l'espace entre ledit moyen formant pont magnétique et la surface arrière (22) de la cible (14).

**8.** Cathode de pulvérisation de magnétron selon la revendication 7, dans lequel l'espace (36) entre ledit moyen formant pont magnétique et la surface arriére (22) de la cible (14) est compris entre 0,025 cm et 0,400 cm.

9. Cathode de pulvérisation de magnétron selon la revendication 7, dans lequel ladite matière à perméabilité magnétique est du fer doux, du Permalloy ou du nickel.

Fig. 1
(Prior Art)

Fig. 2(a)
(Prior Art)

Fig. 2(b)
(Prior Art)

F

T

M

S          N          S

Fig. 2 (c)
(Prior Art)

F

T

M

S          N          S

Fig. 2 (d)
(Prior Art)

Fig 3

Fig. 4

Fig. 5

EP 0 724 652 B1

Fig.6

EP 0 724 652 B1

Fig. 7

Fig. 8

Fig. 9

EP 0 724 652 B1

Fig. 10

Fig. 11

Fig. 12

EP 0 724 652 B1

Fig. 13

Fig. 14

Fig. 15

Fig. 16

EP 0 724 652 B1

Fig. 17

EP 0 724 652 B1

Fig. 18

EP 0 724 652 B1

EP 0 724 652 B1

Fig. 19

414

N
420'

423    419

S
421'

416'

410

Fig. 20

EP 0 724 652 B1